# EUROPÄISCHE PATENTSCHRIFT

(11) **EP 3 335 012 B1**
(45) Veröffentlichungstag und Bekanntmachung des Hinweises auf die Patenterteilung: **02.06.2021**
(21) Anmeldenummer: 16750689.8
(22) Anmeldetag: 29.07.2016
(51) Int. Cl.: G01D 5/243

(54) **ELEKTRONISCHE STEUERUNGSEINHEIT**
ELECTRONIC CONTROL UNIT
UNITÉ DE COMMANDE ELECTRONIQUE

(30) Priorität: 11.08.2015 DE 102015215331
(43) Veröffentlichungstag der Anmeldung: 20.06.2018
(73) Patentinhaber: Continental Teves AG & Co. OHG, 60488 Frankfurt am Main (DE)
(72) Erfinder: ACKER, Heinrich, 65824 Schwalbach (DE)
(74) Vertreter: Continental Corporation
(86) Internationale Anmeldenummer: PCT/EP2016/068158
(87) Internationale Veröffentlichungsnummer: WO 2017/025355

(56) Entgegenhaltungen:
- EP-A1- 1 391 735
- EP-A2- 1 744 184
- CN-A- 103 278 181
- DE-A1- 19 725 806
- DE-A1- 19 745 236

## Beschreibung

Die Erfindung betrifft eine elektronische Steuerungseinheit für eine Vorrichtung zum Messen einer Messgröße. Insbesondere kann es sich bei einer solchen Vorrichtung um einen induktiven Sensor handeln.

Induktive Sensoren basieren typischerweise auf einer Änderung eines oder mehrerer Kennwerte eines Systems eines oder mehrerer induktiver Bauelemente durch eine Messgröße. Derartige induktive Bauelemente können beispielsweise Spule, Wicklung oder Induktivität genannt werden.

Als Kennwerte kommen insbesondere in Frage:
- Selbstinduktivität L, auch kurz Induktivität genannt,
- Verlustwiderstand R, der sich aus einem ohmschen Widerstand der Wicklung und anderen Verlustbeiträgen zusammensetzt,
- komplexe Impedanz Z = jωL + R mit der imaginären Einheit j und der Kreisfrequenz ω,
- Verlustwinkel δ = arctan(Re{Z}/Im{Z}),
- sowie, insbesondere im Falle der magnetischen Kopplung zwischen mehreren Bauelementen, Gegeninduktivität M. Die Gegeninduktivität M kann u.a. als induzierte Spannung in einem Leiter als Reaktion auf einen bekannten Strom in einem anderen Leiter indirekt gemessen werden.

Messgrößen, die die Änderung der Kennwerte bewirken, können unter anderem Position bzw. Länge, Winkel, Kraft, Druck oder Drehmoment sein. Als Anwendung kann beispielhaft ein Positionssensor für das Bremspedal eines Automobils genannt werden.

Die CN103278181 offenbart einen LC-Resonanzsensor.

Für induktive Sensoren existieren im Stand der Technik insbesondere zwei schaltungstechnische Hauptansätze, um eine elektrische Messung der Kennwerte vorzunehmen:
Zum einen ist dies ein resonantes System: Der induktive Sensor mit seinem variablen Kennwert, meist der Induktivität L, ist Teil des frequenzbestimmenden Netzwerks eines Oszillators. Der Oszillator schwingt stets mit seiner Eigenfrequenz, deren wichtigster Einflussfaktor L ist. Die Messung von L ist somit auf eine Frequenzmessung zurückgeführt, die z.B. durch Zählen der Perioden oder Nulldurchgänge der Oszillatorschwingung leicht vorgenommen werden kann.

Zum anderen ist dies ein Lock-in-Verstärker (auch phasenempfindlicher Gleichrichter, Synchrondemodulator oder Trägerfrequenzverstärker) : Der induktive Sensor erhält einen Stimulus mit einer festen Frequenz (Strom oder Spannung). Eine Signalverarbeitungsschaltung misst die jeweils andere elektrische Größe an der Impedanz (Spannung oder Strom). Die Signalverarbeitung entspricht einer schmalbandigen Filterung dieser Größe um die Frequenz des Stimulus mit anschließender Bestimmung der komplexen Amplitude und Quotientenbildung mit dem Stimulus zur Bestimmung des Kennwerts. Diese Funktionen können wahlweise mit analoger Elektronik oder weitgehend mit den Mitteln digitaler Signalverarbeitung und Software realisiert werden.

Beide Ansätze weisen unterschiedliche Nachteile auf.

Das resonante System weist Einschränkungen beim Entwurf des induktiven Systems auf, weil pro Oszillator nur eine Schwingung möglich ist. Mehrere Signale lassen sich nur mit mehreren unabhängigen Oszillatoren und induktiven Systemen gewinnen, wodurch sich der Aufwand für Sensoren mit ratiometrischer oder differentieller Messung deutlich erhöht. Darüber hinaus weist das induktive System stets Frequenzabhängigkeiten auf, d.h. es kann nur für eine Frequenz optimal ausgelegt werden; der Frequenzbereich des Oszillators ist immer ein Kompromiss. Über die Veränderung der Schwingungsfrequenz können Querempfindlichkeiten das Messergebnis verfälschen, weil beispielsweise die Induktivität L zusätzlich zur Empfindlichkeit auf die Messgröße von einer weiteren frequenzabhängigen Größe beeinflusst wird. Schließlich muss die Differenz des maximalen und des minimalen Zählergebnisses der Frequenzmessung einen Mindestwert überschreiten, damit die jeweiligen Anforderungen bezüglich Messgenauigkeit und -auflösung erreicht werden. Dafür ist je nach Frequenz eine minimale Messzeit erforderlich, die unter Umständen gar nicht zur Verfügung steht.

Der Lock-in-Verstärker hingegen arbeitet mit einer konstanten Frequenz, erfordert aber auch einen Stimulus mit dieser Frequenz. Die Frequenz dieser erzwungenen Schwingungen ist frei wählbar, aufgrund der Frequenzabhängigkeit des induktiven Systems stellt dies aber einen Widerspruch zum Betrieb in Resonanz, d.h. mit Schwingungen auf der Eigenfrequenz dar. Daher können die folgenden Vorteile der Resonanz nicht genutzt werden: Das induktive System, als Resonator betrieben, stellt bereits einen Filter dar, indem es in seiner Eigenfrequenz eine besonders hohe Amplitude erreichen kann, die die Messung erleichtert. Störungen, deren Frequenz deutlich von dieser Frequenz abweicht, werden durch die Filterwirkung unterdrückt. Darüber hinaus ist in Resonanz der Leistungsbedarf des induktiven Systems zur Aufrechterhaltung der Schwingung am geringsten, wenn alle anderen Parameter gleich bleiben. Bei gegebener Leistung des Stimulus ist somit eine besonders hohe Amplitude möglich. Diese beiden Vorteile stellen natürlich denselben Sachverhalt dar, einmal aus Sicht der Messung und einmal aus Sicht des Stimulus.

Es ist deshalb eine Aufgabe der Erfindung, eine elektronische Steuerungseinheit für eine im Vergleich zum Stand der Technik alternative, insbesondere verbesserte Vorrichtung zum Messen einer Messgröße zur Verfügung stellen.

Dies wird erfindungsgemäß durch eine elektronische Steuerungseinheit nach Anspruch 1 erreicht. Vorteilhafte Ausgestaltungen können beispielsweise den Unteransprüchen entnommen werden. Der Inhalt der Ansprüche wird durch ausdrückliche Inbezugnahme zum Inhalt der Beschreibung gemacht.

Die Erfindung betrifft eine elektronische Steuerungseinheit für eine Vorrichtung zum Messen einer Messgröße. Die elektronische Steuerungseinheit ist dazu konfiguriert, direkt mit einem Parallelschwingkreis verbunden zu werden, welcher aus einer ersten Induktivität und einer Kapazität gebildet ist. Die elektronische Steuerungseinheit ist dazu konfiguriert, den Parallelschwingkreis mit einer Anregungsfrequenz oszillierend anzuregen, welche aus einem Takt der elektronischen Steuerungseinheit abgeleitet ist.

Die elektronische Steuerungseinheit ist ferner dazu konfiguriert, direkt mit zumindest einer Messinduktivität verbunden zu werden, welche zum Abfühlen der Messgröße ausgebildet ist und welche mit der ersten Induktivität gekoppelt ist. Außerdem ist sie dazu konfiguriert, einen die Messgröße anzeigenden Wert an der Messinduktivität zu messen.

Eine solche elektronische Steuerungseinheit ermöglicht den Aufbau einer Vorrichtung mit besonders vorteilhaften Eigenschaften. Eine solche Vorrichtung zum Messen einer Messgröße weist typischerweise eine erste Induktivität auf. Sie weist eine Messinduktivität auf, welche zum Abfühlen der Messgröße ausgebildet ist und welche mit der ersten Induktivität gekoppelt ist. Außerdem weist sie eine Kapazität auf, welche mit der ersten Induktivität zu einem Parallelschwingkreis verschaltet ist.

Die Vorrichtung weist des Weiteren die erfindungsgemäße elektronische Steuerungseinheit auf. Die elektronische Steuerungseinheit ist direkt mit dem Parallelschwingkreis verbunden und ist wie beschrieben dazu konfiguriert, den Parallelschwingkreis mit einer Anregungsfrequenz oszillierend anzuregen. Außerdem ist die elektronische Steuerungseinheit direkt mit der Messinduktivität verbunden und ist dazu konfiguriert, einen die Messgröße anzeigenden Wert an der Messinduktivität zu messen.

Mittels der Vorrichtung, welche mit der erfindungsgemäßen elektronischen Steuerungseinheit aufgebaut werden kann, kann die Messinduktivität lediglich unter Verwendung einer elektronischen Steuerungseinheit in einem Schwingkreis vermessen werden. Dies spart Energie, da der Schwingkreis von sich aus schwingt und im Regelfall nur verlorene Energie nachgeführt wird. Es findet also eine erzwungene Schwingung statt. Diese erlaubt eine Nutzung der Vorteile der Resonanz und ist von den oben angesprochenen Beschränkungen eines resonanten Systems frei. Die Verwendung einer elektronischen Steuerungseinheit zur Implementierung der Funktionen spart Kosten und vereinfacht das System.

Die Anregung des Schwingkreises kann auch als Stimulus bezeichnet werden. Die Anregungsfrequenz kann auch als Stimulusfrequenz bezeichnet werden. Die Ableitung von einem Takt kann insbesondere durch die Ableitung von einem internen, jedoch auch von einem externen Takt erfolgen. Dies bedeutet insbesondere, dass die Anregungsfrequenz unabhängig ist von einer Resonanzfrequenz des Parallelschwingkreises.

Insbesondere kann die Vorrichtung so aufgebaut sein, dass sie keine zur elektronischen Steuerungseinheit externen Verstärker aufweist. Dies spart ebenfalls Kosten. Typischerweise schließt das Vorsehen einer direkten Verbindung einen jeweiligen Verstärker zwischen elektronischer Steuerungseinheit und Komponente wie Induktivität oder Kapazität bzw. Schwingkreis aus. Ein jeweiliger Verstärker kann insbesondere in der elektronischen Steuerungseinheit integriert sein.

Die Anregungsfrequenz kann insbesondere in einem vorgegebenen Abstand zur Resonanzfrequenz des Parallelschwingkreises vorgegeben bzw. eingestellt sein. Die Wirkung eines Schwingkreises in der Nähe der Resonanzfrequenz bewirkt auch ohne resonante Schwingung vier erfindungsgemäße Vorteile:
1. Die Spannungsspitzen und damit die Gefahr für die Portpins verschwinden.
2. Der Strom durch die Induktivitäten steigt deutlich an, daher wird mehr magnetischer Fluss im induktiven System erzeugt, gleichbedeutend mit einem stärkeren Signal.
3. Der Strom durch die Induktivitäten wird nahezu sinusförmig, was unter Gesichtspunkten der elektromagnetischen Verträglichkeit günstig und für die nachgeschaltete Signalverarbeitung vorteilhaft ist.
4. Der Strom in den Zuleitungen der Schwingkreise sinkt, weil die Impedanz des Schwingkreises in der Nähe der Resonanz besonders hoch ist. Dadurch wird ermöglicht, den Stimulus mit wenigen Portpins bzw. Ausgangsstufen geringer Strombelastbarkeit zu erzeugen.

Zum Schutz der Portpins vor Spannungen außerhalb des zulässigen Bereichs ist der komplementäre Stimulus vorteilhaft, weil dieser eine Schwingung um den Mittelwert der Versorgungsspannung bewirkt. Dabei ist eine Amplitude von ebenfalls der halben Versorgungsspannung möglich bzw. zulässig; je nach Spezifikation des Mikrokontrollers auch darüber hinaus, beispielsweise bis zur halben Versorgungsspannung + 0,5 V. Die Spannungen an den Portpins sind wegen des Innenwiderstandes der Ausgangsstufen typischerweise keine Rechteckspannungen mehr. Ein Stimulus, der einseitig mit Portpins gegen Bezugspotential oder Versorgungsspannung arbeitet, bietet typischerweise keine vergleichbaren Möglichkeiten, denn jeder Stimulus (Wechselspannung), der zu diesen Spannungen addiert wird, liegt bereits bei geringen Amplituden außerhalb des zulässigen Bereichs.

Unter einer elektronischen Steuerungseinheit können beispielsweise ein Mikroprozessor oder ein Mikrokontroller verstanden werden. Unter einem Mikrokontroller ist dabei insbesondere ein Bauelement zu verstehen, das neben den Funktionen eines Mikroprozessors auch Schreib-Lese-Speicher (RAM), mindestens eine Art Festwertspeicher (ROM, EPROM, EEPROM, Flash, o.ä.), Analog-Digital-Konverter (ADC) und/oder Timer- und Portbausteine auf einem Chip integriert enthält. Ein solches Bauelement benötigt typischerweise zum Betrieb keinen externen Speicher und kann ohne Außenbeschaltung ein Programm ausführen sowie Messungen mit dem ADC vornehmen und digitale Signale über Portpins ausgeben, die durch Software oder durch die Timerbausteine bestimmt sind. Dazu erhält der Mikrokontroller typischerweise lediglich eine Spannungs- und Taktversorgung sowie einen Reset-Impuls beim Einschalten. Bei modernen Bauelementen können ein Taktoszillator und eine Reset-Logik auch integriert sein, so dass typischerweise nur die Versorgungsspannung von außen zugeführt wird.

Es kann sich jedoch bei der elektronischen Steuerungseinheit beispielsweise auch um eine Anordnung aus einem Mikroprozessor mit Außenbeschaltung wie Speicher und Taktversorgung, um einen anwendungsspezifischen integrierten Schaltkreis (ASIC), um eine speicherprogrammierbare Steuerung (SPS) oder um einen integrierten Schaltkreis (IC) handeln.

Bevorzugt ist vorgesehen, dass die elektronische Steuerungseinheit als Anwendungsspezifischer Integrierter Schaltkreis, ASIC, und/oder als Anwendungsspezifisches Standardprodukt, ASSP, ausgebildet ist. Dies erlaubt Kostenvorteile durch Massenfertigung, welche einen gewissen Entwicklungsaufwand rechtfertigen.

Zum Messen wird typischerweise ein Analog-Digital-Konverter (ADC) der elektronischen Steuerungseinheit verwendet. Bei den meisten typischerweise verwendbaren Steuerungseinheiten ist der ADC über einen Multiplexer mit einer Anzahl von Portpins verbunden, an denen die Spannung gemessen werden kann. Die Anzahl als Eingang benutzter Portpins und die Abfolge, in der die Eingänge zum ADC durchgeschaltet werden, sind typischerweise konfigurierbar. Die mit dem Multiplexer verbundenen Portpins stehen somit als Eingänge für die Durchführung mehrerer unabhängiger Messungen zur Verfügung.

Es wird davon ausgegangen, dass die Messergebnisse meist nicht nur in der elektronischen Steuerungseinheit verbleiben sollen, sondern an andere Systeme weitergegeben werden, beispielsweise durch eine serielle Schnittstelle. Hierfür können geeignete Bauelemente vorhanden sein.

Es kann auch eine integrierte Schaltung (IC) als elektronische Steuerungseinheit betrachtet oder definiert werden, die die oben genannten Schaltungsfunktionen enthält. Es ist dazu nicht notwendig, dass das IC auch vom Hersteller als elektronische Steuerungseinheit vermarktet wird oder als Standardbaustein frei verkäuflich ist. In diesem Sinne gilt insbesondere ein ASIC ("Application Specific Integrated Circuit", insbesondere ein für eine Kundenapplikation entwickeltes IC), das alle technischen Kriterien erfüllt, als eine elektronische Steuerungseinheit.

Als die Messgröße anzeigender Wert kommen insbesondere in Frage:
- Selbstinduktivität L, auch kurz Induktivität genannt,
- Verlustwiderstand R, der sich aus einem ohmschen Widerstand der Wicklung und anderen Verlustbeiträgen zusammensetzt,
- komplexe Impedanz Z = jωL + R mit der imaginären Einheit j und der Kreisfrequenz ω,
- Verlustwinkel δ = arctan(Re{Z}/Im{Z}),
- sowie, insbesondere im Falle einer magnetischen Kopplung zwischen mehreren Bauelementen, Gegeninduktivität M. Die Gegeninduktivität M kann u.a. als induzierte Spannung in einem Leiter als Reaktion auf einen bekannten Strom in einem anderen Leiter indirekt gemessen werden.

Aus dem die Messgröße anzeigenden Wert kann typischerweise auf die Messgröße geschlossen werden, beispielsweise kann die Messgröße berechnet oder in einer Tabelle nachgeschlagen werden.

Gemäß einer bevorzugten Ausführung ist die elektronische Steuerungseinheit dazu ausgebildet, dass der Parallelschwingkreis an einem ersten Portpin und an einem zweiten Portpin der elektronischen Steuerungseinheit angeschlossen wird. Geschickter Weise wird dabei der zweite Portpin mit einem zum ersten Portpin invertierten Anregungssignal versorgt.

Hierdurch kann erreicht werden, dass eine Schwingung des Parallelschwingkreises nicht um ein Bezugspotential, insbesondere Masse, oder um die Versorgungspannung erfolgt, sondern um die halbe Versorgungsspannung oder zumindest um in etwa in halbe Versorgungsspannung. Dies vermeidet eine Gefährdung der elektronischen Steuerungseinheit bzw. der Portpins oder ihrer Beschaltung.

Die Anregungsfrequenz kann insbesondere durch Herunterteilen oder Übernahme eines Systemtakts am Portpin erreicht werden. Dies erlaubt die Bereitstellung eines mit der Anregungsfrequenz getakteten Signals am Portpin unter Verwendung gängiger Funktionalität einer elektronischen Steuerungseinheit.

Der Stimulus kann insbesondere von einem Systemtakt einer elektronischen Steuerungseinheit abgeleitet werden. Dazu kann ein Timer oder Zähler verwendet werden. Dieser teilt typischerweise den Takt in einem ganzzahligen Verhältnis auf die Frequenz des Stimulus herunter. In manchen Fällen ist auch eine direkte Verwendung des Systemtaktes möglich. Der geteilte Takt wird bevorzugt mit den Ausgangsstufen von zwei oder mehr Portpins verbunden, wobei ein Portpin oder eine Gruppe von Portpins mit dem Takt selbst angesteuert werden, ein zweiter Portpin oder eine zweite Gruppe von Portpins hingegen mit dem invertierten Takt. Je nach Architektur einer elektronischen Steuerungseinrichtung kann es dabei notwendig sein, für jeden Portpin einen eigenen Timer zu verwenden, weil jeder Timer nur mit einem bestimmten Portpin verbunden werden kann, ohne dass eine Möglichkeit zur Verzweigung des Timersignals besteht. Dieser Umstand stellt meist kein Problem dar, weil moderne Steuerungseinheiten typischerweise über viele Timer verfügen und meist nur wenige Portpins benötigt werden, minimal zwei.

Da die Auswahl der Frequenz des Stimulus durch Einstellung des Timers erfolgen kann, kann diese Frequenz im Betrieb des Systems durch Software optional verändert werden.

Gemäß einer Ausführung kann zwischen einer Anzahl der Portpins und einer Induktivität, also beispielsweise der ersten Induktivität oder der Messinduktivität, ein jeweiliger Widerstand, insbesondere ein Ohm'scher Widerstand, verschaltet sein. Auch dies sei noch unter einem direkten Anschluss verstanden. Mit dem Widerstand kann insbesondere ein Strom begrenzt werden, was eine Beschädigung aufgrund Überlastung vermeidet.

Die elektronische Steuerungseinheit kann dazu ausgebildet sein, dass der Parallelschwingkreis parallel zum ersten Portpin mit einer Anzahl weiterer erster Portpins verbunden wird, welche zum ersten Portpin synchron geschalten werden. Die elektronische Steuerungseinheit kann auch dazu ausgebildet sein, dass der Parallelschwingkreis parallel zum zweiten Portpin mit einer Anzahl weiterer zweiter Portpins verbunden wird, welche zum zweiten Portpin synchron geschalten werden. Damit können die jeweiligen maximalen Strombelastungen der Portpins addiert werden, so dass insgesamt ein höherer maximaler Strom erreicht werden kann als bei Verwendung nur eines Portpins.

Unter einer synchronen Schaltung ist dabei insbesondere zu verstehen, dass an den jeweiligen Portpins grundsätzlich das gleiche Potential anliegt, dieses also auch gleichzeitig umgeschaltet wird. Die elektronische Steuerungseinheit ist bevorzugt zu einer solchen synchronen Schaltung ausgelegt bzw. konfiguriert.

Die Spannungen an den Portpins dienen insbesondere als Stimulus. Es gibt hauptsächlich zwei Gründe, optional anstelle eines einzelnen Portpins, welches mit dem Takt versorgt wird, sowie eines einzelnen Portpins, welches mit dem invertierten Takt versorgt wird, jeweils eine Gruppe von Portpins zu verwenden. Zum einen kann eine Anzahl Portpins, die eine zu geringe Strombelastbarkeit aufweisen, durch Parallelschaltung einen entsprechend der Anzahl vielfachen Strom bereitstellen, wie bereits weiter oben erwähnt. So können induktive Systeme mit einem Stimulus versorgt werden, deren Impedanz andernfalls zu gering wäre. Zum anderen kann das induktive System mehrere mit Stimulus zu versorgende Induktivitäten vorsehen. In diesem Fall kann die Verwendung eines Timers pro Portpin optional auch ermöglichen, die einzelnen Induktivitäten mit Stimuli unterschiedlicher Frequenz oder Phasenlage zu versorgen.

Es sei deshalb erwähnt, dass auch das Anschließen weiterer Induktivitäten an weitere Portpins möglich ist.

Bevorzugt weisen Portpins, an welchen der Parallelschwingkreis angeschlossen ist, eine Push-Pull-Ausgangsstufe oder eine Tristate-Ausgangsstufe auf. Dies kann insbesondere bedeuten, dass je ein Schaltelement (Bipolar- oder MOS-Transistor) für eine niederohmige Verbindung zu den Spannungen der beiden Logikpegel vorhanden ist. Derartige Ausführungen haben sich für die vorliegende Anwendung als vorteilhaft erwiesen.

Gemäß einer bevorzugten Ausführung ist vorgesehen, dass sich die Anregungsfrequenz um maximal 25 %, bevorzugt maximal 20 %, besonders bevorzugt maximal 15 %, noch weiter bevorzugt maximal 10 % von einer Resonanzfrequenz des Parallelschwingkreises unterscheidet. Insbesondere kann die elektronische Steuerungseinheit zum Vorsehen einer solchen Anregungsfrequenz ausgebildet sein. Sie kann dazu ausgebildet sein, die Resonanzfrequenz zu ermitteln, beispielsweise wie weiter unten beschrieben. Sie kann auch dazu ausgebildet sein, einen definierten Abstand zwischen Anregungsfrequenz und Resonanzfrequenz vorzusehen und/oder eine Gleichheit von Anregungsfrequenz und Resonanzfrequenz zu verhindern. Damit wird eine vorteilhafte Anregung erreicht. Ein Betrieb bei Resonanzfrequenz ist typischerweise nicht beabsichtigt, kann jedoch als Grenzfall normalerweise toleriert werden.

Die Schaltung des Stimulus, wie insbesondere auch die hierin beschriebene Messschaltung, skaliert gut und lässt sich ohne Änderung der Anforderungen an die elektronische Steuerungseinheit bzw. den Mikrokontroller mit Anregungsfrequenzen vom kHz-Bereich bis in den MHz-Bereich betreiben, z.B. bevorzugt von 5 kHz bis 5 MHz. Dazu werden typischerweise nur die Parameter des induktiven Systems und des Kondensators des Schwingkreises angepasst. Die Untergrenze von 5 kHz bewirkt insbesondere, dass die Induktivitäten ausreichend klein ausgeführt werden können und das System, an dem gemessen werden soll, möglichst wenig beeinflussen. Die Obergrenze bewirkt insbesondere, dass die parasitären Kapazitäten der Portpins und des angeschlossenen äußeren Netzwerks gemeinsam mit den Innenwiderständen der Ausgangsstufen keine dann wirksamen Tiefpässe bilden. Es sei jedoch verstanden, dass auch Frequenzen außerhalb des angegebenen Bereichs verwendet werden können, da maximal tolerierbare Einflüsse immer von den tatsächlichen Gegebenheiten abhängen.

Innerhalb des angestrebten Stimulus-Frequenzbereiches ist der obere Bereich, z.B. von 500 kHz bis 5 MHz, für viele Messaufgaben, besonders im Automobil, bevorzugt geeignet. Das induktive System ist dann sehr klein und kann, da die benötigten Induktivitäten nur wenige Mikrohenry betragen, auch in Form von planaren Spulen kompakt und kostengünstig auf einer Leiterplatte integriert werden. Wird das induktive Systems in Form von planaren Spulen realisiert, so ist eine Stimulus-Frequenz im oberen Bereich besonders bevorzugt, weil die Impedanzen im induktiven System andernfalls typischerweise zu klein werden, um einer präzisen Messung ohne hohen Aufwand zugänglich zu sein.

Bevorzugt ist die elektronische Steuerungseinheit dazu ausgebildet, die Messinduktivität mit zu vermessen, wenn sie mit einem ersten Pol an einem Portpin der elektronischen Steuerungseinheit angeschlossen ist, und mit einem zweiten Pol mit einem Potential verbunden ist, welches zumindest annähernd der halben Versorgungsspannung der elektronischen Steuerungseinheit entspricht.

Unter einer zumindest annähernd halben Versorgungsspannung kann dabei insbesondere ein Wert verstanden, welcher eine Abweichung von ± 10 % oder ± 5 % von der halben Versorgungsspannung hat. Es kann auch exakt die halbe Versorgungsspannung verwendet werden. Eine Abweichung von diesem exakten Wert führt nicht zu einem Messfehler, sondern kann ggf. lediglich die erreichbare Auflösung verschlechtern.

Das Potential, welches zumindest annähernd der halben Versorgungsspannung der elektronischen Steuerungseinheit entspricht, kann beispielsweise mittels eines Spannungsteilers erzeugt werden.

Das Potential, welches zumindest annähernd der halben Versorgungsspannung der elektronischen Steuerungseinheit entspricht, kann auch mittels eines Glättungskondensators erzeugt werden, wobei der Glättungskondensator mit einem ersten Pol mit einem Bezugspotential oder mit der Versorgungsspannung verbunden ist, und wobei ein zweiter Pol des Glättungskondensators über einen Widerstand mit einem Portpin der elektronischen Steuerungseinheit verbunden ist, welcher mit einem gepulsten Signal, insbesondere mit einem Signal mit vorgebbarem Tastverhältnis, beaufschlagt wird.

Die elektronische Steuerungseinheit kann dementsprechend dazu ausgebildet sein, an einem Portpin ein gepulstes Signal, insbesondere ein Signal mit vorgebbarem Tastverhältnis, auszugeben, um das Potential, welches zumindest annähernd der halben Versorgungsspannung der elektronischen Steuerungseinheit entspricht mittels des Glättungskondensators zu erzeugen.

Der Widerstand kann dabei insbesondere zum Erreichen einer kleinen Restwelligkeit ausgelegt sein, wobei er bevorzugt einen Widerstandswert von über 100 kΩ hat.

Die eben beschriebenen Ausführungen beruhen auf der Erkenntnis, dass die Spannungen an den Portpins die durch die Versorgungsspannung gegebenen Grenzen typischerweise nur minimal überschreiten dürfen. Für die Sekundärwicklungen eines Messtransformators bedeutet das, dass sie vorzugsweise nicht einfach einseitig mit Bezugspotential oder VDD verbunden und mit dem anderen Anschluss an den Portpin angeschlossen werden, denn in einem solchen Fall würden typischerweise bereits kleine Amplituden aus dem Versorgungsspannungsbereich herausführen. Stattdessen wird bevorzugt das angegebene Potential von etwa der halben Versorgungsspannung verwendet, um maximale Amplituden zu ermöglichen.

Dies kann mit einem einfachen Spannungsteiler gelöst werden, was einer einfachen Ausführung entspricht. Es kann auch wie angegeben ein RC-Glied verwendet werden. Der Kondensator wird einseitig mit der Versorgungsspannung oder Bezugspotential verbunden, die andere Seite wird mit einem Anschluss einer Sekundärwicklung des Messtransformators verbunden. An diesem Knoten ist ebenfalls der Widerstand angeschlossen, dessen Wert typischerweise im Bereich von über 100 kΩ liegt. Die andere Seite des Widerstandes ist mit einem Portpin verbunden. Typischerweise wechselt dabei die Ausgangsstufe timergesteuert zwischen den Logikpegeln und ggf. auch dem hochohmigen Zustand einer Tristate- Ausgangsstufe, um die Kondensatorspannung ungefähr bei der halben Versorgungsspannung zu halten. Besonders vorteilhaft ist dabei, wenn Timer des Mikrokontrollers einen Pulsweitenmodulator bilden können, weil dann für die Korrektur von Parameteränderungen nur das Pulsweitenmodulation (PWM)-Verhältnis eingestellt werden muss. Eine Zentraleinheit wird dann nur wenig mit dieser Aufgabe belastet. Der Widerstandswert im RC-Glied soll bevorzugt hoch sein, damit die Spannung bei der halben Versorgungsspannung nur eine geringe Restwelligkeit aufweist. Aufgrund der Filterwirkung der Messschaltung kann die Auswirkung der Restwelligkeit minimiert werden, indem die Signalfrequenz, die von einem Analog-Digital-Wandler (ADC) gemessen werden soll, einen hinreichenden Abstand von der PWM-Frequenz hält.

Das RC-Glied bietet insbesondere die Möglichkeit, eine weitere Verbesserung der messtechnischen Eigenschaften der Schaltung zu erreichen. Die Restwelligkeit am Kondensator kann gezielt als sogenannter "Dither" (engl. "zittern") eingesetzt werden, um die Auflösung der Messung zu erhöhen. Dabei wird ein Hilfssignal geringer Amplitude (die Restwelligkeit) zu einem Nutzsignal addiert. Durch mehrfaches Abtasten des Summensignals kann dann die Auflösung bei der Messung des Nutzsignals gesteigert werden. Das Verfahren ist unter dem Namen "Dithering" bekannt. Es sei erwähnt, dass das Dithering auch anderweitig, also beispielsweise ohne RC-Glied vorgesehen werden kann.

Die Filterfunktion kann anstelle des einfachen RC-Gliedes auch durch andere passive Tiefpässe erfolgen.

Bevorzugt ist die elektronische Steuerungseinheit dazu konfiguriert, beim Einschalten zunächst den Glättungskondensator auf die zumindest annähernd halbe Versorgungsspannung aufzuladen, während Portpins, an welchen der Parallelschwingkreis angeschlossen ist, den gleichen Logikpegel aufweisen, und erst danach eine Anregung des Parallelschwingkreises zu beginnen.

Zur Vorteilhaftigkeit dieses Vorgehens sei folgendes ausgeführt.

Die Verwendung von Induktivitäten bewirkt sowohl an den Portpins, die den Stimulus erzeugen, als auch an den Portpins, die der Messung dienen, die Gefahr von Überspannungen, die einen Mikrokontroller zerstören können. Maßnahmen zum Schutz des Mikrokontrollers wie ein in Serie geschalteter Widerstand beziehen sich auf den eingeschwungenen Zustand. Beim Einschalten des Systems können jedoch Überspannungen auftreten, auch wenn die Schaltung so aufgebaut ist, dass im eingeschwungenen Zustand keine Gefahr besteht. Zur Vermeidung einer Beschädigung ist eine auf Schutz ausgelegte Einschaltprozedur vorteilhaft, wenn die Verwendung von Schutzbauelementen eigens für den Einschaltvorgang vermieden werden soll. Es handelt sich dabei um einen Ablauf, der von der Zentraleinheit der elektronischen Steuerungseinheit bzw. des Mikrokontrollers per Programm durchgeführt werden kann. Sobald der eingeschwungene Zustand erreicht wurde, sind typischerweise keine gesonderten Maßnahmen mehr notwendig und der Messbetrieb kann beginnen.

Die Einschaltprozedur beginnt bevorzugt mit der Messschaltung, währenddessen bleibt der Stimulus noch abgeschaltet. Alle vorhandenen RC-Glieder bzw. passiven Tiefpässe, die der Erzeugung einer Spannung von etwa der halben Versorgungsspannung dienen, werden vorzugsweise vorgeladen, damit sie ihren Zweck erfüllen können. Wird der Stimulus aktiviert, bevor ungefähr die halbe Versorgungsspannung an den entsprechenden Knoten erreicht wurde, so können die induzierten Spannungen zu einer Verletzung des zulässigen Spannungsbereichs führen. In diesem Zusammenhang wirkt es störend, dass der Widerstand der RC-Glieder wie oben beschrieben hoch sein muss, denn dadurch kann das Vorladen sehr lange dauern, was eine unerwünschte Verzögerung zwischen dem Einschalten der Versorgungsspannung und der Messbereitschaft des Sensorsystems verursacht. Dies kann vermieden werden, indem die Kapazitäten der RC-Glieder stattdessen durch die ebenfalls angeschlossenen Induktivitäten und die entsprechenden Portpins aufgeladen werden. Dazu kann es notwendig sein, Strombegrenzungswiderstände an diesen Portpins vorzusehen, wenn keine Ausgangsstufen bzw. Konfigurationen von Ausgangsstufen vorhandenen sind, mit denen eine Strombegrenzung im Mikrokontroller vorgenommen werden kann, etwa durch schaltbare integrierte Pull-up-Widerstände.

Solange das Vorladen der RC-Glieder läuft, sollen die beiden Anschlüsse der elektronischen Steuerungseinheit bzw. des Mikrokontrollers, die den Stimulus bereitstellen, den gleichen Logikpegel aufweisen, damit kein Strom durch die entsprechende Induktivität fließt. Die Induktivität ist für Gleichstrom sehr niederohmig und kommt einem Kurzschluss gleich, der diese Anschlüsse zerstören würde. Vorteilhaft ist auch der hochohmige Zustand von Tristate-Ausgängen. Wird schließlich der Stimulus gestartet, so soll er bevorzugt an beiden Anschlüssen fast gleichzeitig aktiviert werden, um den unvermeidlichen Kurzschluss beim ersten Pegelwechsel des ersten Anschlusses so kurz wie möglich zu halten. Das Programm ist bevorzugt so zu schreiben bzw. die elektronische Steuerungseinheit ist bevorzugt so zu konfigurieren, dass die Verzögerung zwischen den Aktivierungszeitpunkten der Ausgänge deterministisch ist, indem andere Aktivitäten blockiert werden, z.B. kein Interrupt zugelassen wird.

Die elektronische Steuerungseinheit weist bevorzugt einen Analog-Digital-Wandler auf, um ein von der Messinduktivität erzeugtes Signal zu erfassen, wobei unter Berücksichtigung von Aliasing dessen Kennwerte, insbesondere Amplitude, Phase, Realteil und/oder Imaginärteil bestimmt werden, vorzugsweise bei der Anregungsfrequenz.

Vorteilhaft ist die elektronische Steuerungseinheit dazu konfiguriert, aus einem in der elektronischen Steuerungseinheit erfassten Signal eine Frequenzkomponente bei einer Auswertungsfrequenz zu ermitteln, wobei die Auswertungsfrequenz insbesondere die Anregungsfrequenz oder ein Alias der Anregungsfrequenz ist.

Zu derartigen Ausführungen seien die nachfolgenden Bemerkungen gegeben.

Wenn die gewählte Stimulus-Frequenz so hoch ist, dass die Nyquist-Frequenz des ADC auch bei maximal möglicher Abtastrate darunter liegt, so kann Unterabtastung gezielt eingesetzt werden. Dabei erscheint das Signal des Stimulus durch Aliasing bei einer Frequenz unterhalb der jeweiligen Nyquist-Frequenz am Ausgang des ADC; Aliasing ist hier also keine Störung oder ein Ausschlusskriterium, sondern erwünscht. Nachrichtentechnisch gesehen handelt es sich beim Stimulus um einen amplitudenmodulierten Träger, denn wenn sich die Messgröße ändert, kommt es zu einer Amplitudenmodulation (AM) des Stimulus mit der Messgröße. Daraus leiten sich die Breite der AM-Seitenbänder und die Forderung ab, dass die Abtastrate für eine korrekte Funktion des erfindungsgemäßen Systems bevorzugt mindestens vier Mal so hoch sein soll wie die Bandbreite in der Messgröße, damit sich die Bänder nicht durch Aliasing störend überlappen, denn das AM-Signal weist die doppelte Bandbreite des Signals der Messgröße auf. Da das Signal des Stimulus selbst sehr schmalbandig ist - der Spulenstrom ist durch die Ergänzung des induktiven Systems zum Schwingkreis typischerweise fast sinusförmig - und die Bänder bei niederfrequenten Messgrößen leicht schmal gegenüber der Nyquist-Bandbreite des Analog-Digital-Wandlers (ADC) gestaltet werden können, sind keine gesonderten Maßnahmen notwendig, um ein unerwünschtes Überlappen von Bändern durch Aliasing und damit eine Verfälschung des Signals zu verhindern.

Da die Messinduktivität oder allgemein die Induktivitäten, an denen die zu messenden Spannungen abgegriffen werden, typischerweise niederohmig sind, stellt Rauschen kein wesentliches Problem dar. Nur der geringe ohmsche Widerstand der Induktivitäten stellt eine Rauschquelle dar. Aus dem gleichen Grund müssen typischerweise breitbandige Störquellen in der Umgebung des Sensors sehr große Amplituden aufweisen, um die Messung wesentlich zu beeinflussen: der geringe ohmsche Widerstand wirkt für kapazitiv oder induktiv gekoppelte Störquellen fast wie ein Kurzschluss, weil fast die gesamte Störspannung an der Koppelimpedanz abfällt. Lediglich schmalbandige Störer erreichen bei den meisten Anwendungen Amplituden, die für die Messschaltung relevant sind. Daher ist eine ebenfalls schmalbandige Filterung der zu messenden Spannungen sinnvoll.

Eine solche Filterung erfolgt typischerweise digital, indem eine Reihe von Abtastwerten des ADC benutzt wird, um die Stimulus-Frequenz im Eingangs-Frequenzgemisch zu isolieren. Dazu kann eine Implementierung der DFT (Diskrete Fourier-Transformation) benutzt werden, deren Algorithmus von einer Zentraleinheit der elektronischen Steuerungseinheit bzw. des Mikrokontrollers ausgeführt wird. Besonders bevorzugt ist die Verwendung eines Goertzel-Filters bzw. Goertzel-Algorithmus, der numerisch besonders effizient Betrag und Phase einer einzelnen Spektrallinie der DFT liefern kann. Als Frequenz dieser Spektrallinie ist bevorzugt die Frequenz des Stimulus, also die Anregungsfrequenz bzw. derjenigen Alias-Frequenz, die durch eine Unterabtastung der Anregungsfrequenz entsteht, zu wählen.

Gemäß einer Ausführung ist die Messinduktivität galvanisch mit der ersten Induktivität gekoppelt. Gemäß einer weiteren Ausführung ist die Messinduktivität magnetisch mit der ersten Induktivität gekoppelt. Die Messinduktivität kann insbesondere mit der ersten Induktivität durch Ausbildung als Messtransformator gekoppelt sein. Derartige Ausführungen haben sich für typische Anwendungen als vorteilhaft erwiesen.

Die erste Induktivität, die Messinduktivität und/oder die Kapazität sind bevorzugt Bauteile mit einer jeweiligen Toleranz zwischen 1 % und 10 %, bevorzugt von 1 %, oder von weniger als 1 %. Die Toleranz gibt dabei typischerweise die bauartbedingte maximale Abweichung zu einem Sollwert vor. Entsprechend geringe Toleranzen erleichtern vorliegend die Konzeption der Vorrichtung insbesondere im Kontext einer Massenfertigung, da bei einer geringen Toleranz auch die maximale Abweichung der Resonanzfrequenz des Parallelschwingkreises entsprechend gering ist.

Gemäß einer bevorzugten Ausführung ist vorgesehen, dass
- der Parallelschwingkreis eine maximale Güte aufweist, welche durch Maximierung eines Werts von Vt * Vt / V0 erhalten wird,
- wobei Vt ein Verhältnis aus Spulenstrom und Zuleitungsstrom bei maximaler Abweichung der Kapazität und der ersten Induktivität von ihren jeweiligen Werten bei der Resonanzfrequenz des Parallelschwingkreises bezeichnet, und
- wobei V0 ein Verhältnis aus Spulenstrom und Zuleitungsstrom bei jeweiligen Werten von Kapazität und erster Induktivität bei der Resonanzfrequenz des Parallelschwingkreises bezeichnet.

Die maximale Güte kann insbesondere durch Verschalten eines Widerstands im Parallelschwingkreis begrenzt werden.

Die maximale Abweichung wird typischerweise durch die Toleranz, also die weiter oben bereits erwähnte maximale Abweichung zum Sollwert, des jeweiligen Bauteils vorgegeben.

Zur Güte und zur eben erwähnten vorteilhaften Ausführung werden nachfolgend einige Ausführungen gegeben.

Passive Bauelemente der Elektrotechnik, wie z.B. Spulen und Kondensatoren, werden üblicherweise mit Toleranzen ihrer Kennwerte angeboten, die typischerweise zwischen 1 % und 10 % liegen. Noch niedrigere Werte als 1 % führen meist zu sehr hohen Kosten für die Bauelemente. Toleranzen von mehr als 10 % machen es demgegenüber schwierig, Schaltungen überhaupt sinnvoll auszulegen. Wird ein Schwingkreis aus toleranzbehafteten Bauelementen mit den Kennwerten L und C (Kapazität) aufgebaut, so ergibt sich aus der Schwingungsformel für die Resonanzfrequenz ω₀ = 1/√(LC), dass die Toleranz der Resonanzfrequenz ω₀ dem geometrischen Mittel √(LC) der Toleranzen der Bauelemente entspricht. Die Toleranz der Resonanzfrequenz von Schwingkreisen, die mit den üblichen Bauelementen aufgebaut sind, bewegt sich daher ebenfalls im Bereich von 1 % bis 10 %. Wird ein Schwingkreis so ausgelegt, dass seine nominale Resonanzfrequenz mit der Frequenz des Stimulus, also der Anregungsfrequenz übereinstimmt, muss man davon ausgehen, dass die reale Resonanzfrequenz um ± 1 % bis ± 10 % abweicht.

Eine wichtige Eigenschaft von Schwingkreisen ist ihre Güte Q. Sie ist ein Maß für die Verluste, die durch den ohmschen Widerstand im Kreis auftreten und für das Abklingen einer freien Schwingung. Je höher die Güte, desto geringer die Verluste und desto langsamer das Abklingen.

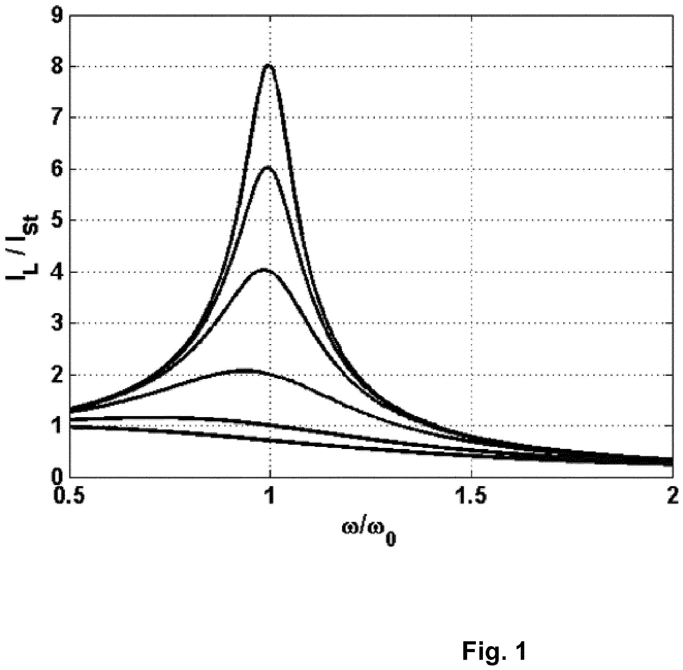

Figur 1 zeigt eine Kurvenschar, die die Auswirkung der Güte auf den Nutzen der Ergänzung des induktiven Systems zum Schwingkreis in Bezug auf den Stimulus, also die Anregung durch die Anregungsschaltung zeigt. Aufgetragen ist das Verhältnis des Stromes I_{L} durch die angeregte Induktivität zum Strom I_{St} des Stimulus. Ohne Ergänzung des induktiven Systems zum Schwingkreis wäre dieses Verhältnis immer gleich eins, weil es keinen weiteren Strompfad gibt. Da der Strom I_{L} dem Nutzstrom entspricht, weil durch ihn der magnetische Fluss erzeugt wird, während der Strom I_{St} dem Aufwand entspricht, bedeutet der aufgetragene Quotient einen Bewertungsfaktor für den Nutzen. Werte größer eins entsprechen einem Gewinn. Dieser Nutzen ist über die auf die Resonanzkreisfrequenz ω₀ normierte Kreisfrequenz ω aufgetragen. Der Scharparameter ist die Güte; der Wert bei ω₀ in jeder Kurve entspricht dabei dem Wert der Güte, d.h. die Kurven stellen die Güte Q mit den Werten 8; 6; 4; 2; 1; 1/√2 (von oben nach unten) dar.

Betrachtet man nun den Nutzen der Ergänzung des induktiven Systems zum Schwingkreis bei Frequenzen, die um beispielsweise ± 10 % von der Resonanzkreisfrequenz ω₀ abweichen, so stellt man fest, dass sich auch für diese Frequenzen ein hoher Nutzen einstellen kann, nicht nur bei der Nominalfrequenz. Je höher die Güte, desto höher ist jedoch das Verhältnis aus dem Nutzen bei der Resonanzfrequenz ω₀ und dem Nutzen bei einer Frequenz, die um ± 10 % abweicht. Grund ist der bekannte Zusammenhang, dass die Bandbreite der Resonanzüberhöhung bei zunehmender Güte immer schmaler wird. Für die Auslegung der hierin beschriebenen Vorrichtung besteht daher folgender Zielkonflikt: Einerseits sollte die Güte für einen möglichst hohen gütebedingten Nutzen möglichst hoch sein; andererseits bewirkt ein hohes Verhältnis des Nutzens in der Mitte (Resonanz) und an den Rändern des Toleranzbereichs eine Reduzierung der Nutzbarkeit, die sich folgendermaßen erklärt: Jedes übliche Messsystem, ob analog oder digital, hat eine maximale Eingangsamplitude, die typischerweise nicht überschritten werden darf. Im Rahmen dieses Maximums ist die relative Auflösung zum Eingangssignal proportional, weil der kleinste unterscheidbare Schritt des Eingangssignals im Eingangssignalbereich konstant ist. Wird nun der Eingangssignalbereich bei Resonanz voll ausgeschöpft, so ist der sich aus Figur 1 ergebende Nutzen auch voll nutzbar. An den Rändern des Toleranzbereiches jedoch ist der Nutzen reduziert um den Faktor, der sich aus dem Verhältnis des Nutzens in der Mitte (Resonanz) und an den Rändern des Toleranzbereichs ergibt.

Ziel ist eine optimale Auslegung des Sensorsystems im Rahmen des Entwurfs. Zunächst ist anzustreben, die Toleranz der Bauelementkennwerte L und C, bzw. ihr geometrisches Mittel √(LC), möglichst gering zu halten. Dabei ist hilfreich, dass in den letzten Jahren Kondensatoren mit Toleranzen von 1 % und besser verfügbar und billiger geworden sind. Die hauptsächliche Bedeutung für die Optimierung kommt aber der optimalen Wahl der Güte zu. Generell lassen sich hohe Gütewerte typischerweise nur in Kombination mit geringen Toleranzen des Terms √(LC) vorteilhaft nutzen. Das im Folgenden beschriebene Auslegungsverfahren basiert daher auf dem Gedanken, aufgrund der Verfügbarkeit geeigneter, eng tolerierter Kondensatoren und des Entwurfs eines induktiven Systems für die jeweilige Anwendung eine Toleranz für √(LC) festzulegen, aus der dann die optimale Güte berechnet werden kann.

Mit der Toleranz von √ (LC) ist auch die Toleranz der Kreisfrequenz ω durch die Schwingungsformel festgelegt. Aus Figur 1 kann nun der Wert für I_{L}/I_{St} abgelesen werden für ω₀ (Resonanz) und ω_{T} (Kreisfrequenz gegeben durch die Toleranz; es kann die untere Frequenzgrenze gewählt werden, die obere oder beide). Dies kann auch numerisch geschehen; die Berechnung von Fig. 1 aus dem Zuleitungsstrom I_{St} und dem Spulenstrom I_{L} für einen Parallelschwingkreis gegebener Güte ist elementare Elektrotechnik und wird hier vorausgesetzt. Dadurch sind die Größen V0 = I_{L} (ω0)/I_{St} (ω₀) und Vt = I_{L} (ω_{T})/I_{St} (ω_{T}) nun bekannt. Für eine Frequenz ω_{T} gilt dann: Der Bruchteil, mit dem der Eingangsspannungsbereich des Messsystems ausgeschöpft wird, ist durch den Term Vt/V0 gegeben. Bei dieser Frequenz ist der Nutzen, der durch die Ergänzung des induktiven Signals zum Schwingkreis erhalten wird, gleich Vt. Somit beträgt der Faktor, mit dem das ganze System von der Ergänzung des induktiven Signals zum Schwingkreis profitiert, das Produkt beider Terme: Vt²/V0. Durch elementare Umformungen der zugrundeliegenden Gleichungen kann dieser Faktor berechnet werden als Funktion von ω₀, ω_{T} und Q. Die Optimierung eines Systems besteht dann darin, Vt²/V0 zu maximieren, wodurch sich ein Ergebnis für Q in Abhängigkeit von ω₀ und ω_{T} ergibt. Durch weitere elementare mathematische Umformungen lässt sich auch Q in Abhängigkeit von ω₀ und ω_{T} auftragen. Aus einer solchen Darstellung lässt sich Q direkt ablesen, man spart sich so das wiederholte Einsetzen von Werten für Q in die Berechnung zur Maximumsuche. In beiden Fällen sind die Ergebnisse für Q stets maximale Werte, d.h. für ein entsprechend ausgelegtes System mit ω₀ und ω_{T} soll Q die berechneten Werte nie überschreiten, weil sonst der zugrunde gelegte Eingangssignalbereich des Messsystems verletzt wird. Bei einer Unterschreitung des berechneten Wertes von Q tritt keine Verletzung auf; der Eingangssignalbereich des Messsystems wird lediglich nicht ausgeschöpft. Dies ist wichtig für die Auslegung des Schwingkreises, da eine zu hohe Güte Q stets in einfacher Weise durch Hinzufügen eines ohmschen Widerstandes herabgesetzt werden kann; es bereitet jedoch u.U. große Schwierigkeiten, eine niedrige durch die Eigenschaften des induktiven Systems gegebene Güte Q konstruktiv zu erhöhen. Ursache ist der parasitäre Charakter des Verlustwiderstandes in induktiven Bauelementen, der insbesondere in Sensorinduktivitäten oft hoch ist, weil ihre Windungen ausgedehnt und die magnetischen Kreise offen sind.

Es ergibt sich insgesamt folgende vorteilhafte Vorgehensweise bzw. folgendes Verfahren, zusammengefasst aus den obenstehenden Erläuterungen:
1. Auslegung des induktiven Systems (weitgehend außerhalb des Themas dieser Anmeldung)
2. Festlegung der Arbeitsfrequenz des induktiven Systems (weitgehend außerhalb des Themas dieser Anmeldung, da von der Auslegung bestimmt)
3. Auswahl eines Kondensators mit möglichst geringer Toleranz (dies kann insbesondere nach kommerziellen Kriterien erfolgen)
4. Berechnung des geometrischen Mittels der Toleranz der Bauelementwerte L und C
5. Bestimmung der Frequenz ω_{T} aus (4.)
6. Wiederholte Berechnung und Maximierung von Vt²/V0; Ergebnis ist die maximal zulässige Güte Q mit den gewählten Parametern
7. Ist die Güte des Schwingkreises aus L, C und seinem konstruktiv bedingten Verlustwiderstand kleiner als die maximal zulässige Güte Q? Wenn ja, fertig.
8. Wenn nein, Einfügen eines Widerstandes in den Schwingkreis, der die Güte auf den maximal zulässigen Wert herabsetzt.

Es sei verstanden, dass die eben beschriebenen Verfahrensschritte als Ganzes oder in beliebiger Unterkombination einen eigenständigen Erfindungsaspekt darstellen können.

Aus diesen Ausführungen leitet sich insbesondere die oben beschriebene Vorgehensweise bei der Bestimmung der Güte ab.

Die Messgröße kann beispielsweise durch Verändern einer Position eines magnetischen Kerns in der Messinduktivität abgefühlt werden. Dies kann den Wert der Induktivität der Messinduktivität ändern.

Die Messgröße kann auch durch Verändern eines Abstands zwischen Messinduktivität und erster Induktivität abgefühlt werden. Dies entspricht typischerweise einer Ausführung als Messtransformator, wobei die magnetische Kopplung verändert wird.

Außerdem kann die Messgröße beispielsweise durch Verändern einer Position eines magnetischen und leitfähigen, eines unmagnetischen und leitfähigen, oder eines magnetischen und nicht leitfähigen Elements benachbart zu Messinduktivität und erster Induktivität abgefühlt werden. Dies erlaubt eine Anpassung an unterschiedliche Aufgaben und Gegebenheiten. Das Element kann beispielsweise zwischen oder auch neben erster Induktivität und Messinduktivität angeordnet sein. Durch das Verändern seiner Position wird die Kopplung zwischen erster Induktivität und Messinduktivität verändert.

Ein magnetisches und leitfähiges Element kann beispielsweise aus Stahl sein. Ein unmagnetisches und leitfähiges Element kann beispielsweise aus Aluminium sein. Ein magnetisches und nicht leitfähiges Element kann beispielsweise aus Ferrit sein.

Die Messinduktivität kann insbesondere dazu ausgebildet sein, eine Messgröße in Form einer Position, einer Länge, eines Winkels, einer Kraft, eines Drucks und/oder eines Drehmoments abzufühlen. Dies entspricht typischen Einsatzszenarien.

Die elektronische Steuerungseinheit ist vorzugsweise dazu ausgebildet, einen oder mehrere der folgenden Kennwerte über der Messinduktivität zu messen:
- Selbstinduktivität bzw. Induktivität,
- Verlustwiderstand,
- komplexe Impedanz,
- Verlustwinkel,
- Gegeninduktivität zur ersten Induktivität.

Aus solchen Kennwerten kann typischerweise auf die Messgröße geschlossen werden.

Gemäß einer Weiterbildung ist vorgesehen, dass die Vorrichtung zwei, drei oder mehr als drei Messinduktivitäten aufweist bzw. dass die elektronische Steuerungseinheit hierfür ausgebildet ist. Diese können beispielsweise einzeln oder auch zusammen bewegbar ausgebildet sein. Sie können insbesondere von der gleichen Messgröße beeinflusst werden, so dass eine Kompensation von Störgrößen, insbesondere der Temperatur, möglich ist. Insbesondere kann die Vorrichtung eine erste Messinduktivität und eine zweite Messinduktivität aufweisen, wobei die erste Messinduktivität an einem ersten Längsende der ersten Induktivität angeordnet ist und die zweite Messinduktivität an einem zweiten Längsende der ersten Induktivität angeordnet ist. Eine solche Ausführung hat sich für typische Anwendungen als vorteilhaft erwiesen.

Die elektronische Steuerungseinheit weist erfindungsgemäß ein Direkte-Digitale-Synthese (DDS) -Modul auf, um die Anregungsfrequenz zu erzeugen. Derartige DDS-Module sind im Stand der Technik bekannt und erlauben die nahezu stufenlose Einstellung der Anregungsfrequenz bei vorgegebenem Takt. Sie sind typischerweise nicht Bestandteil eines Mikrokontrollers, können jedoch insbesondere für eine speziell entwickelte Steuerungseinheit, insbesondere als Application Specific Standard Product, verwendet bzw. einem Design hinzugefügt werden.

Ein DDS-Modul erlaubt typischerweise eine wesentlich feinere Einstellung der Anregungsfrequenz als dies durch Herunterteilen eines Systemtakts möglich ist. Wird beispielsweise ein Systemtakt von 24 MHz verwendet, so kann mit einem Teiler von 5 eine Anregungsfrequenz von 4,8 MHz erreicht werden. Mit dem nächsthöheren Teiler von 6 kann eine Anregungsfrequenz von 4 MHz erreicht werden. Im Vergleich dazu ist die Anregungsfrequenz mittels eines typischen DDS-Moduls nahezu kontinuierlich einstellbar.

Nachfolgend werden einige Ausführungen zu DDS-Modulen gegeben.

DDS bedeutet englisch "Direct Digital Synthesis" und bezeichnet ein an sich bekanntes Verfahren, das hier mit dem induktiven Sensorsystem nach Art eines Lock-in-Verstärkers und allen in dieser Anmeldung genannten Merkmalen in einem ASIC/ASSP kombiniert ist. Dabei typischerweise wird ein Oszillator fester Frequenz benutzt, um Frequenzen zu erzeugen, die in einem bestimmten Intervall nahezu beliebig wählbar sind. Dazu wird typischerweise ein Register, d.h. ein Speicher für eine digital repräsentierte Zahl, verwendet, in dem jeweils der aktuelle Wert der Phase des auszugebenden Signals gespeichert ist. In jedem Taktzyklus des Oszillators wird typischerweise der Wert eines weiteren Registers, des Inkrementregisters, zu dem ersten Register, dem Phasenregister, hinzuaddiert. In jedem Zyklus erhöht sich also der Wert des Phasenregisters um einen konstanten Wert und ist damit der Zeit proportional. Der maximale Zahlenbereich, den das Phasenregister darstellen kann, entspricht dabei der Periode des auszugebenden Signals. Daher sind beim Überlauf des Phasenregisters keine speziellen Maßnahmen zu ergreifen; die Phasenwerte nehmen in der gewählten Zahlendarstellung, üblicherweise Zweierkomplement, in der nächsten Signalperiode einfach wieder vom negativsten Wert ansteigende Werte an.

An den Ausgang des Phasenregisters ist typischerweise ein digitaler Speicher (z.B. ein ROM) angeschlossen, dessen Adresse aus dem Phasenregister gewonnen wird. Im einfachsten Fall sind die Registerbits dabei mit den Adressleitungen des Speichers direkt verbunden. Meistens wird eine Konfiguration gewählt, bei der die Wortbreite des Phasenregisters deutlich mehr Bit umfasst als die Anzahl der Adressleitungen des Speichers. Dies ist besonders vorteilhaft. Der Speicher ist dann mit den höchstwertigen Adressleitungen verbunden. Die niederwertigen Bits des Phasenregisters erlauben es aber, einen besonders genauen Phasenwert zu speichern.

In Zusammenhang mit einer entsprechenden Auslegung des Inkrementregisters, in dem diese Bits ebenfalls vorhanden sind, kann die Frequenz dann in besonders engen Abstufungen eingestellt werden.

Der Speicher hat typischerweise die Aufgabe, die Kurvenform des auszugebenden Signals abzubilden. Dort ist besonders vorteilhaft der Verlauf einer Sinuskurve abgespeichert. Indem nun die Adresse des Speichers vom Phasenregister vorgegeben wird, erhöht sie sich ebenfalls proportional zur Zeit, wobei das Inkrementregister die Proportionalitätskonstante darstellt, d.h. die Frequenz. Am Ausgang des Speichers liegen daher aufeinanderfolgende Datenworte vor, die in der gewählten Zahlendarstellung z.B. einer Sinuskurve entsprechen.

Die Datenworte werden typischerweise einem D/A-Wandler zugeführt, dessen Ausgang anstelle eines einfachen Inverters mit dem Portpin verbunden ist, an dem die elektronische Steuerungseinheit den Stimulus der Schaltung zur Verfügung stellt. Es wird je ein D/A-Wandler pro Stimulus-Portpin benötigt, ggf. können Teilstrukturen der Wandler gemeinsam benutzt werden, um Siliziumfläche zu sparen. Für den Aufbau der D/A-Wandler ist es vorteilhaft, Inverter mit gestaffelter Strombelastbarkeit parallel zu schalten und die einzelnen Transistoren durch die Datenworte des Speichers zu aktivieren, anstatt einen Standard-Wandler zu benutzen, der die Spannung als Ausgangsgröße verwendet. Inverter gestaffelter Strombelastbarkeit entstehen insbesondere durch Transistoren unterschiedlicher Größe (v.a. Kanalweite bei MOS-Transistoren, Emitterfläche bei Bipolartransistoren).

Für maximale Einfachheit und minimierte Siliziumfläche des Systems ist es möglich, bestimmte Leistungskennziffern der Kombination aus DDS und Digital-Analog (D/A)-Wandler absichtlich auf sehr geringen Werten zu halten, die sonst kaum anzutreffen sind. Da z.B. der Oberwellengehalt am Ausgang des D/A-Wandlers nur einen minimalen Einfluss auf das Messergebnis hat (das System funktioniert typischerweise auch mit Rechteck-Stimulus), kann die Wortbreite des D/A-Wandlers gering gehalten werden. Außerdem muss nur eine einzige Signalform und -amplitude ausgegeben werden können. Daher ist es nicht notwendig, die Signalwerte, die vom D/A-Wandler ausgegeben werden können, äquidistant zu machen. Der D/A-Wandler soll nur die Werte erzeugen können, die von dieser Signalform und -amplitude benötigt werden. Für eine sinusförmige Ausgabe bedeutet das, dass die Stufen in der Mitte grob, an den Rändern des Bereichs jedoch fein gestaffelt werden können. Für diese Ausführung enthält der Speicher dann keine Werte mehr, die in seinem Zahlenraum einen nichtlinearen Verlauf darstellen. Im einfachsten Fall kann der Speicher dann durch eine Kombination aus Zählern ersetzt werden.

Für die Anwendung in der induktiven Sensorik weist die Schaltung mit DDS und Digital-Analog-Wandler zwei wichtige Vorteile auf, die beide darauf basieren, dass der Wert des Inkrementregisters, der sich bei Ausgabe eines Signals mit konstanter Frequenz nicht ändert, von einer übergeordneten Logikeinheit, welche insbesondere in der elektronischen Steuerungseinheit integriert sein kann, gesteuert werden kann. Dies entspricht einer Frequenzmodulation (FM) des Stimulus.

Erstens kann das System mit Hilfe der Anpassung der Stimulus-Frequenz die Resonanzfrequenz des angeschlossenen Schwingkreises im laufenden Betrieb suchen. Toleranzen dieser Resonanzfrequenz, ob durch Streuung von Fertigungsparametern oder Einflüsse wie etwa die Temperatur werden dadurch bedeutungslos. Weiterhin arbeitet die Schaltung bei der Resonanzfrequenz immer im Maximum bezüglich der Filterwirkung des Schwingkreises, der spektralen Reinheit der Signale, der Amplitude des Magnetfeldes bei gegebenem Stimulus-Strom sowie resultierend daraus bei maximalem Signal-zu-Rausch-Verhältnis.

Alle diese Eigenschaften können ohne die Frequenzmodulation typischerweise nur angenähert realisiert werden, und zwar insbesondere begrenzt von der Toleranz der Resonanzfrequenz. Es muss in diesem Zusammenhang betont werden, dass der Schwingkreis immer noch erzwungene Schwingungen bei einer festen, von außen vorgegebenen Frequenz ausführt und nicht etwa frei in Resonanz schwingt. Sollte die Güte des Schwingkreises zu hoch sein, so kann das Programm des Mikrokontrollers ebenfalls vorsehen, die Resonanzfrequenz zu meiden, um eine Überschreitung des Eingangsspannungsbereichs für die induzierten Spannungen auf der Messseite zu vermeiden. Ebenfalls erweitern sich die Messmöglichkeiten hinsichtlich induktiver Systeme, deren Resonanzfrequenz sich im Betrieb stark durch die Messgröße verändern kann. Das Programm des Mikrokontrollers kann dann vorsehen, der Resonanzfrequenz zu folgen, um jeweils eine große Amplitude der induzierten Spannungen zu erreichen und die gemessene Resonanzfrequenz als Messwert zu verwenden bzw. in die Berechnung einzubeziehen.

Mit einem ganz ähnlichen Programm, jedoch ohne Suche nach der Resonanz, kann die gleiche Schaltung Impedanzspektroskopie durchführen und dadurch wesentlich mehr Information aus dem induktiven System extrahieren. Impedanzspektroskopie bedeutet, Spektren der Parameter des induktiven Systems zu messen. Schließlich bedeutet jeder Betrieb mit der Resonanzfrequenz eine Minimierung der Verlustleistung.

Aus den eben beschriebenen Vorteilen und Möglichkeiten leitet sich eine vorteilhafte Ausführung ab. Die elektronische Steuerungseinheit ist gemäß dieser Ausführung dazu konfiguriert, durch Verändern der Anregungsfrequenz eine Resonanzfrequenz des Parallelschwingkreises zu ermitteln. Dies kann für diverse Steuerungsaufgaben verwendet werden, welche auf der Resonanzfrequenz basieren. Insbesondere kann die elektronische Steuerungseinheit ferner dazu ausgebildet sein, die Anregungsfrequenz identisch zur Resonanzfrequenz oder benachbart zur Resonanzfrequenz einzustellen. Insbesondere kann ein gewünschter Abstand, beispielsweise relativ oder absolut, zwischen Anregungsfrequenz und Resonanzfrequenz vorgegeben sein. Dieser kann positiv oder negativ sein.

Zweitens kann die Frequenzmodulation zur Störunterdrückung verwendet werden, wenn entweder innerhalb eines Messintervalls ständig die Messfrequenz leicht verändert wird, so dass jeder schmalbandige Störer nur in einem Teil des Messintervalls tatsächlich stört, oder das Programm des Mikrokontrollers nach Frequenzen sucht, bei denen ein besonders hohes Signal-Rausch-Verhältnis gefunden wird, um dann auf diesen zu verbleiben, solange sich die Verhältnisse nicht verschlechtern.

Hieraus leitet sich eine bevorzugte Ausführung ab, in welcher die elektronische Steuerungseinheit dazu konfiguriert ist, eine erfolgte oder bevorstehende Überschreitung eines maximalen Pegels an einem Portpin zu erkennen, und ansprechend darauf die Anregungsfrequenz zu ändern, insbesondere weiter von der Resonanzfrequenz des Parallelschwingkreises zu beabstanden. Damit kann in einfacher und zuverlässiger Weise einer Überschreitung zulässiger Pegel mit den dafür typischen Konsequenzen wie Messfehler oder Beschädigung vermieden werden.

Die elektronische Steuerungseinheit kann dazu konfiguriert sein, eine Störunterdrückung auszuführen.

Hierzu kann die Anregungsfrequenz kontinuierlich innerhalb eines Messintervalls, beispielsweise zwischen einer unteren Frequenz und einer oberen Frequenz, variiert werden. Dies erlaubt die Elimination von Störgrößen, welche typischerweise nur in einem engen Frequenzbereich wirksam sind, so dass die Anregungsfrequenz bei der Variation nur eine relativ kurze Zeit über eine Frequenz der Störgröße hinwegstreicht.

Die Anregungsfrequenz kann auch innerhalb eines Messintervalls variiert werden, wobei abhängig von der Anregungsfrequenz ein Signal-zu-Rausch-Verhältnis ermittelt wird. Nachfolgend wird die Anregungsfrequenz auf einen Wert mit maximalem Signal-zu-Rausch-Verhältnis eingestellt. Dies erlaubt eine automatisierte und einfache Optimierung des Signal-zu-Rausch-Verhältnisses.

Die elektronische Steuerungseinheit weist gemäß einer bevorzugten Ausführung zumindest einen Analogmultiplizierer auf, welcher an einen Portpin zum Anschluss der Messinduktivität angeschlossen ist. Die elektronische Steuereinheit weist ein Signalmodul auf, das erfindungsgemäß als Direkte-Digitale-Synthese (DDS)-Modul ausgebildet ist. Das Signalmodul liefert dabei ein oszillierendes Signal mit einer Frequenz mit definiertem, insbesondere geringem Abstand zur Anregungsfrequenz. Der Abstand kann beispielsweise 5 % oder 10 % betragen.

Ein Ausgangssignal des Analogmultiplizierers, insbesondere eine Signalkomponente bei der Differenzfrequenz, wird vorzugsweise in der elektronischen Steuerungseinheit zur Ermittlung der Messgröße weiterverarbeitet.

Zur Verwendung eines Analogmultiplizierers seien die nachfolgenden Ausführungen gegeben.

Zusätzlich zum DDS kann ein Funktionsblock eingefügt werden, der typischerweise ebenfalls nicht in Mikrokontrollern enthalten ist. Dies ist ein Analogmultiplizierer als Mischer, der die Signale von je einer der zu vermessenden Induktivitäten an einem der Eingänge erhalten kann, während am anderen Eingang eine Schwingung angelegt wird, die ebenfalls von einem DDS-Block wie oben geschildert erzeugt werden kann. Diese Schwingung soll eine Frequenz aufweisen, die sich nur um wenige Prozent von der Frequenz des Stimulus unterscheidet. Am Ausgang des Multiplizierers erscheint dann eine Schwingung, die ein Gemisch aus Signalen mit der Summen- und der Differenzfrequenz darstellt. Diese Schwingung wird an den ADC weitergeleitet und dort in gleicher Weise verarbeitet. Allerdings wird aus dem Frequenzgemisch vorteilhaft nur die Differenzfrequenz gemessen, indem die bereits beschriebene digitale Filterung mit DFT oder Goertzel-Filter auf die Differenzfrequenz eingestellt wird. Da die Differenzfrequenz wesentlich niedriger ist, stellt die Messung dieses Signalanteils wesentlich geringere Anforderungen an den ADC und den Taktgenerator, deren Phasenrauschen bzw. Jitter andernfalls die Genauigkeit der Messung begrenzen können. Somit lässt sich mit Einsatz eines zweiten DDS und Multiplizierern (insbesondere einer pro Messkanal oder einer für alle Messkanäle, dann vorteilhaft im Signalfluss hinter einem Multiplexer) eine Verbesserung der Messeigenschaften erzielen, die ebenfalls nicht mit einem Mikrokontroller möglich ist.

Es ist dabei bevorzugt, dass die Frequenz des Stimulus und die Frequenz, die der zweite DDS-Block ausgibt, nicht gleich sind.

Der zweite DDS-Block wäre dann typischerweise auch überflüssig, weil in beiden Fällen das gleiche Signal verwendet werden könnte. Die Differenzfrequenz wäre jedoch gleich Null, wenn die Frequenzen gleich sind, d.h. die ausgegebene Spannung eine Gleichspannung ist. Dies würde zwar die digitale Signalverarbeitung erleichtern, weil dann weder DFT noch Goertzel-Filter nötig wären, jedoch lässt sich eine Schwingung mit der von Null verschiedenen Differenzfrequenz besser durch Filterung isolieren als die Gleichspannung. Außerdem ist der Informationsgehalt höher, denn die Schwingung wird durch Amplitude, Phase und Mittelwert charakterisiert, die Gleichspannung nur durch einen Wert.

Insgesamt ist das DDS-Modul dann typischerweise doppelt vorhanden, wobei ein Digital-Analog-Konverter für das zweite DDS-Modul mit kleineren Transistoren oder anderen Schaltungsprinzipien ausgeführt werden kann, um Chipfläche einzusparen, denn der Ausgang wirkt ja nur auf interne Knoten der Schaltung.

Die Vorrichtung, welche mittels der erfindungsgemäßen elektronischen Steuerungseinheit aufgebaut werden kann, kann beispielsweise einen Oszillator, einen optionalen Verstärker, ein induktives System, einen Schwingkreiskondensator, einen optionalen Messverstärker und ein Messsystem, insbesondere die Messvorrichtung aufweisen. Der Verstärker verstärkt das Signal des Oszillators, er kann insbesondere entfallen, wenn der Ausgang des Oszillators bereits ein hinreichend starkes Signal bereitstellt. Dieses Signal oder das des Verstärkers bilden den Stimulus für das induktive System, welches durch den Kondensator zum Schwingkreis ergänzt wird. Insbesondere können die weiter oben bereits erwähnte erste Induktivität und die ebenfalls bereits erwähnte Messinduktivität als induktives System angesehen werden. Falls das Ausgangssignal zu schwach für das Messsystem ist, kann ein zusätzlicher Messverstärker verwendet werden, andernfalls kann insbesondere das Messsystem direkt mit dem induktiven System verbunden werden, beispielsweise indem eine elektrische Größe oder mehrere elektrische Größen am induktiven System abgegriffen wird oder werden. Das Messsystem kann beispielsweise als in analoger oder digitaler Technik und ggf. Software implementierter Lock-in-Verstärker (bzw. phasenempfindlicher Gleichrichter, Synchrondemodulator oder Trägerfrequenzverstärker) ausgeführt sein und kann unter Zuhilfenahme des Oszillatorsignals als Referenzsignal einen oder mehrere Kennwerte des induktiven Systems ermitteln.

Bevorzugt ist die Anregungsfrequenz einstellbar. Insbesondere kann sie softwaremäßig einstellbar sein. Dies erlaubt eine Modulation der Anregungsfrequenz bzw. des Stimulus. Alternativ kann die Anregungsfrequenz auch fest vorgegeben sein.

Die elektronische Steuerungseinheit kann für die hierin beschriebene Messung insbesondere als Lock-In-Verstärker ausgebildet bzw. konfiguriert sein. Dieser kann auch als phasenempfindlicher Gleichrichter, Synchrondemodulator oder Trägerfrequenzverstärker bezeichnet werden und hat sich für die hier relevante Anwendung als vorteilhaft erwiesen.

Durch die beschriebene Auslegung eines induktiven Systems und einer Kombination aus den hierin beschriebenen Komponenten wird erreicht, dass die Überhöhung der für die Messung maßgeblichen Größen, wie sie für Resonanz charakteristisch ist, in Verbindung mit einem Signalverarbeitungsweg, wie er vom Lock-in-Verstärker bekannt ist, verbunden werden kann. Dadurch wird der Strombedarf eines induktiven Sensorsystems verringert und/oder seine Messauflösung wird erhöht. Für die praktische Auslegung von induktiven Sensorsystemen mit offenen magnetischen Kreisen können für Vt²/V0 vorteilhaft typische Werte im Bereich von 3 bis 8 verwendet bzw. erwartet werden.

Es sei verstanden, dass sich die Erfindung auch auf eine Vorrichtung mit einer erfindungsgemäßen elektronischen Steuerungseinheit bezieht. Dabei kann auf alle beschriebenen Ausführungen und Varianten zurückgegriffen werden. Die Vorrichtung in allen Varianten kann insbesondere auch separat beansprucht werden.

Weitere Merkmale und Vorteile wird der Fachmann aus den nachfolgend mit Bezug auf die beigefügte Zeichnung beschriebenen Ausführungsbeispielen entnehmen.
Figur 1 zeigt beispielhafte Verläufe einer Güte, auf welche bereits weiter oben in dieser Anmeldung eingegangen wurde.
Figur 2 zeigt eine Vorrichtung mit einer elektronischen Steuerungseinheit gemäß einem ersten Ausführungsbeispiel der Erfindung.
Figur 3 zeigt eine Vorrichtung mit einer elektronischen Steuerungseinheit gemäß einem zweiten Ausführungsbeispiel der Erfindung.
Figur 4 zeigt eine Innenbeschaltung für Portpins.
Figur 5 zeigt eine Ausführung eines Digital-Analog-Wandlers.
Figur 6 zeigt eine Schaltung zur Signalerzeugung mittels DDS.

Figur 1 wurde bereits weiter oben im Text erwähnt und erläutert.

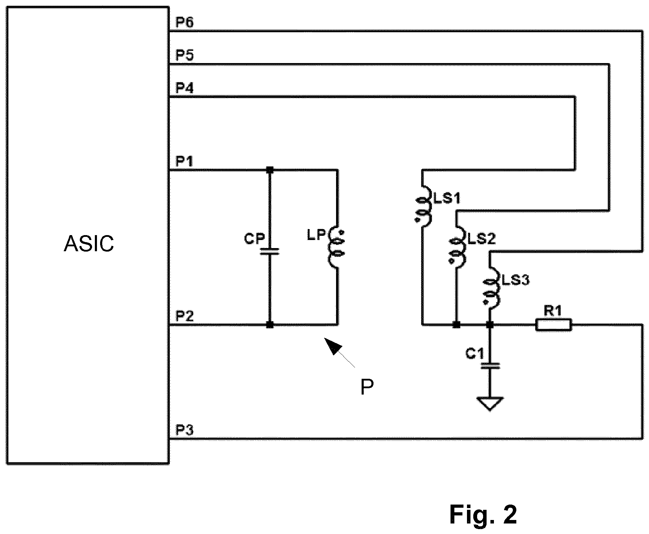

Figur 2 zeigt eine Vorrichtung mit einer elektronischen Steuerungseinheit gemäß einem ersten Ausführungsbeispiel der Erfindung mit einer elektronischen Steuerungseinheit in Form eines Anwendungsspezifischen Integrierten Schaltkreises (ASIC = Application Specific Integrated Circuit) . Ein induktives System ist dabei als Messtransformator aus erster Induktivität LP sowie drei Messinduktivitäten, nämlich einer ersten Messinduktivität LS1, einer zweiten Messinduktivität LS2 und einer dritten Messinduktivität LS3 ausgeführt. Ein Stimulus wird durch Portpins P1 und P2 des ASIC bereitgestellt, die von einem internen DDS-Modul mit einer vorgesehenen Anregungsfrequenz bzw. Stimulus-Frequenz angesteuert werden.

Parallel zur ersten Induktivität LP ist eine Kapazität CP geschaltet, wodurch sich ein Parallelschwingkreis P ergibt. Die Schwingungen des Schwingkreises P werden fortlaufend durch alternierende Spannungen an P1 und P2 aufrechterhalten, so dass sich eine Schwingung konstanter Amplitude ergibt.

Der Strom durch die erste Induktivität LP bewirkt einen magnetischen Fluss, der auch die Messinduktivitäten LS1, LS2, LS3 erfasst. Die magnetische Kopplung wird durch den Pfeil symbolisiert. Der Prozentsatz des magnetischen Flusses der ersten Induktivität LP, der auch durch die Messinduktivitäten LS1, LS2 und LS3 geht, hängt dabei von der Messgröße ab. Im vorliegenden Ausführungsbeispiel kann sich der Abstand von erster Induktivität LP und den Messinduktivitäten LS1, LS2 und LS3 ändern, um diesen zu messen.

Es könnte sich aber alternativ auch beispielsweise ein weichmagnetischer Kern oder ein elektrisch leitfähiger Körper zwischen der ersten Induktivität LP und den Messinduktivitäten LS1, LS2 und LS3 befinden, dessen Bewegung gemessen wird.

Jegliche Anordnung, die eine Parameteränderung des induktiven Systems bewirkt, ist grundsätzlich möglich.

Grundsätzlich induziert der magnetische Fluss in den Messinduktivitäten LS1, LS2 und LS3 Spannungen, die Portpins P4, P5, P6 des ASIC zugeleitet werden. Ein Vorteil der Verwendung von drei Induktivtäten LS1, LS2 und LS3 anstelle einer einzigen ist die Möglichkeit, mehr Daten zur Messung der Messgröße zu gewinnen. Werte der Messinduktivitäten LS1, LS2 und LS3 hängen daher in unterschiedlicher Weise von der Messgröße ab, so dass etwaige Messfehler an einer der Messinduktivitäten LS1, LS2, LS3 durch rechnerische Berücksichtigung der Messwerte an allen Messinduktivtäten LS1, LS2 und LS3 korrigiert werden können. Insbesondere kann dabei eine Kompensation der typischerweise wichtigsten Störgröße, nämlich der Temperatur, vorgenommen werden. Alternativ können jedoch auch mehrere Messgrößen mit einem System erfasst werden.

Die Spannungen an den Portpins P4, P5, P6 werden wechselweise über einen integrierten Multiplexer einem Analog-Digital-Konverter (ADC) im ASIC zugeleitet. Der ADC erfasst jede dieser Spannungen mehrfach. Aus der Mehrzahl an Abtastwerten, die durch den ADC für jede Spannung ermittelt werden, wird die Amplitude und Phase bei der Stimulus-Frequenz ermittelt. Weitere Schritte digitaler Signalverarbeitung und Software können vorgenommen werden, um aus den Amplituden- und Phasenwerten schließlich den Messwert für die Messgröße zu bestimmen.

Wie gezeigt sind die Messinduktivitäten LS1, LS2, LS3 an ihren jeweiligen Polen, welche den mit den Portpins P4, P5, P6 verbundenen Polen gegenüberliegen, mit einem gemeinsamen Potential verbunden, welches durch einen Glättungskondensator C1 definiert wird. Der Glättungskondensator C1 ist an seinem Pol, welcher dieses Potential definiert, über einen Widerstand R1 mit einem Portpin P3 des ASIC verbunden. An diesem Portpin P3 legt der ASIC im Betrieb ein pulsweitenmoduliertes Signal an, um im Mittel ein bestimmtes Potential an dem Glättungskondensator C1 aufrechtzuerhalten. Dieses Potential entspricht in etwa der halben Versorgungsspannung des ASIC.

Es sei explizit darauf hingewiesen, dass außer den bereits erwähnten Komponenten ASIC, erste Induktivität LP, Messinduktivitäten LS1, LS2, LS3, Kapazität CP, Glättungskondensator C1 und Widerstand R1 keine weiteren Komponenten in der Vorrichtung nach dem gezeigten Ausführungsbeispiel vorhanden sind. Insbesondere sind alle passiven Bauteile direkt an dem ASIC angeschlossen. Auf das Vorsehen zusätzlicher aktiver Komponenten wie Verstärker wird also verzichtet, was die Kosten minimiert.

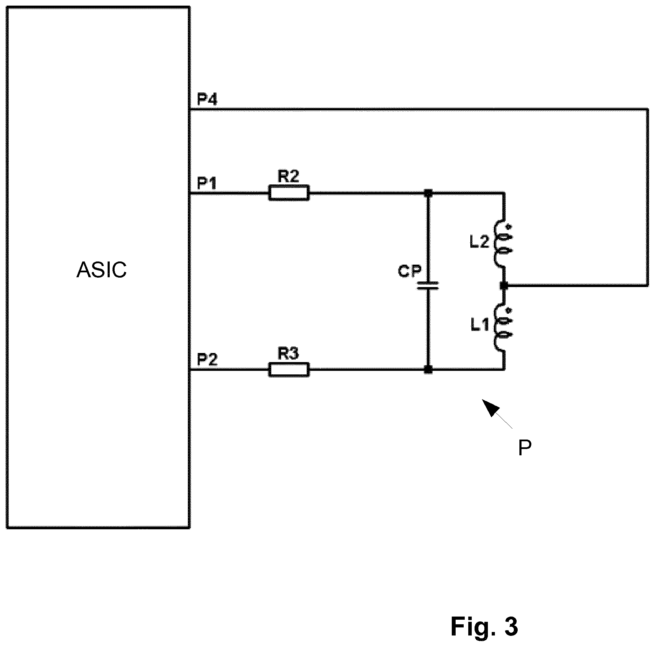

Figur 3 zeigt ein eine Vorrichtung gemäß einem zweiten Ausführungsbeispiel der Erfindung. Auch dabei ist ein ASIC vorgesehen. Die Unterschiede in der Beschaltung im Vergleich zur Vorrichtung gemäß dem ersten Ausführungsbeispiel werden nachfolgend erläutert.

Bei der Vorrichtung gemäß dem zweien Ausführungsbeispiel sind alle Induktivitäten galvanisch gekoppelt. Ein Parallelschwingkreis P wird von einer ersten Induktivität L1, einer Messinduktivität L2 und einer Kapazität CP gebildet. Die Messinduktivität L2 ist auf die Messgröße empfindlich und verändert sich, während die erste Induktivität L1 einen konstanten Wert aufweist. In den Verbindungsleitungen zu den Portpins P1, P2 befinden sich Widerstände R2 und R3, die die Portpins P1, P2 vor zu hohen Strömen schützen. Zwischen der ersten Induktivität L1 und der Messinduktivität L2 wird eine Spannung abgegriffen, die mit der Stimulus-Frequenz schwingt und deren Amplitude und Phase von der Messgröße abhängt. Bezüglich weiterer Aspekte sei auf Figur 2 verwiesen.

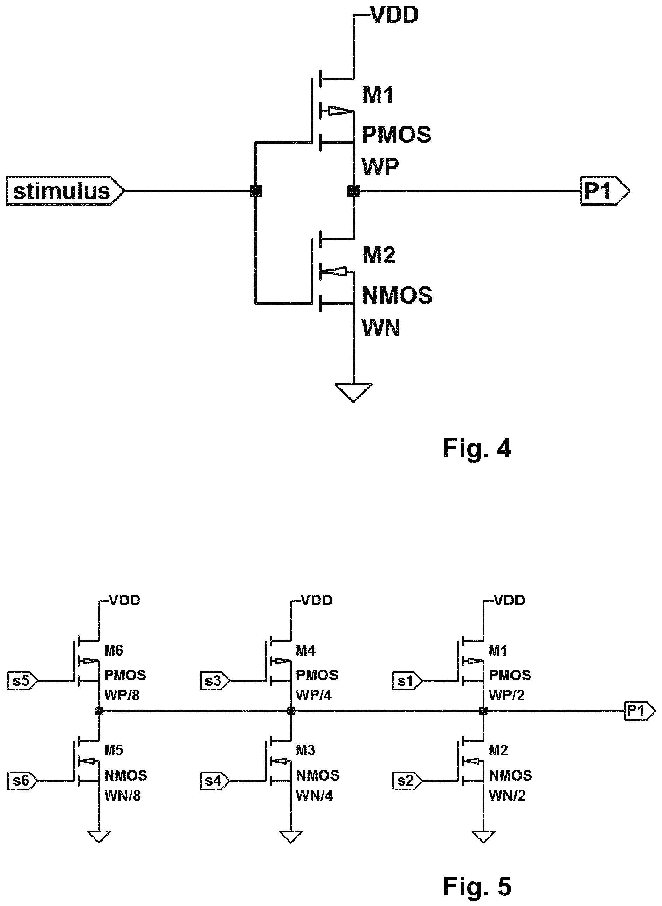

Figur 4 zeigt eine mögliche Innenbeschaltung an P1 und P2 insbesondere für den Fall der Verwendung eines Standard-Portpins eines ASIC oder einer anderen elektronischen Komponente in CMOS-Technologie. Ein Inverter wird aus MOS-Transistoren M1 und M2 gebildet, wobei der P-MOSFET M1 die Kanalweite WP hat und der N-MOSFET M2 die in der vorliegenden Technologie dazu passende Kanalweite WN. Die Schaltung wird vom Stimulus-Signal gesteuert; ihr Ausgang ist mit dem eigentlichen Port-Pin P1 verbunden, die gleiche Struktur kann sich noch einmal an P2 befinden. Eine Versorgungsspannung ist mit VDD bezeichnet, was auch für andere Figuren gilt.

Eine mögliche Ausführungsform für einen Digital-Analog-Wandler ist in Figur 5 gezeigt. Es sind nun drei Inverter mit den Transistoren M1 bis M6 vorhanden, wobei die Kanalweiten der Transistoren gestaffelt sind und die Werte WP/2, WP/4 und WP/8 bzw. WN/2, WN/4 und WN/8 annehmen. Auf der Eingangsseite sind die Transistoren nicht als Inverter geschaltet, sondern mit Eingangssignalen s1 bis s6 versorgt. Diese Eingangssignale sind so zu schalten, dass jeweils einer oder mehrere der P-MOSFETs M1, M4, M6 leitend werden oder einer oder mehrere der N-MOSFETs M2, M3, M5 leitend werden, jedoch nie Transistoren beider Gruppen, weil dies lediglich einen nutzlosen direkten Stromfluss von der Versorgungsspannung VDD nach Masse zur Folge hätte. Zusammen mit dem ebenfalls zulässigen Fall, dass alle Transistoren sperren, ergeben sich somit 15 Zustände des Digital-Analog-Wandlers (7 Kombinationen mit leitenden P-MOSFETs, 7 Kombinationen mit leitenden N-MOSFETs und alle gesperrt). Die Zustände unterscheiden sich in der Impedanz zwischen P1 und einer der Versorgungsspannungen (VDD bzw. Masse) und der jeweiligen Versorgungsspannung. Dadurch kann der Stimulus in 15 Impedanz- bzw. Spannungsstufen und entsprechenden Strömen anstelle von nur zwei Stufen erzeugt werden, wenn die Signale s1 bis s6 zyklisch so verändert werden, dass alle Stufen durchlaufen werden. Die Schaltung ist hinsichtlich ihrer Siliziumfläche sehr effizient, weil der Flächenverbrauch maßgeblich durch die Kanalweite bestimmt ist und die summierte Kanalweite der Transistoren M1 bis M6 diejenige aus Fig. 4 nicht übersteigt. Anders formuliert wird in beiden Fällen die gleiche Summen-Kanalweite für die gleiche Summen-Strombelastbarkeit benötigt.

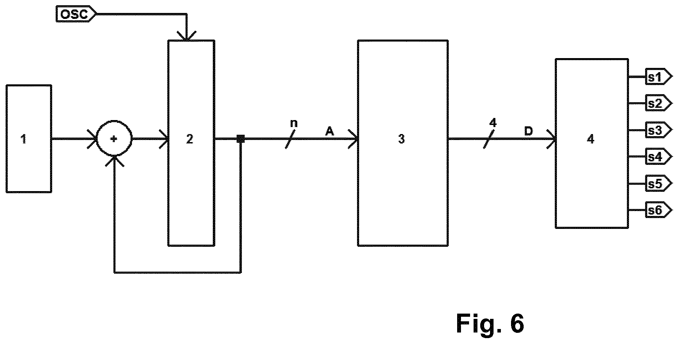

Eine Schaltung zur Erzeugung der Signale s1 bis s6 mittels DDS ist in Fig. 6 gezeigt. Die Ausgänge eines Inkrementregisters 1 und eines Phasenregisters 2 wirken auf einen Addierer, dessen Ausgang mit dem Eingang des Phasenregisters 2 verbunden ist. Bei jedem Takt am Takteingang des Phasenregisters, der von einem Oszillatorsignal OSC fester Frequenz gespeist wird, wird dadurch der Wert des Phasenregisters um den Wert des Inkrementregisters erhöht. In diesem Ausführungsbeispiel wird der Inhalt des Inkrementregisters als Konstante angenommen und deshalb kein Eingang zum Setzen dieses Registers dargestellt. Der Ausgang des Phasenregisters 2 ist mit dem Adressbus A eines Speichers 3 verbunden, wodurch bestimmte Adressen des Speichers 3 ausgewählt werden. Der Adressbus hat eine Breite von n Bit. Am Ausgang des Speichers 3, dem Datenbus D, erscheinen daraufhin die zu den Adressen korrespondierenden Datenworte. Der Datenbus hat hier eine Breite von 4 Bit, weil die 15 Zustände des korrespondierenden Digital-Analog-Wandlers aus Fig. 5 mit 4 Bit codiert werden können. Die Datenworte des Datenbusses D werden einem Decoder 4 zugeleitet, der die Umsetzung auf die Signale s1 bis s6 vornimmt. Jeder der 15 Möglichkeiten, den Digital-Analog-Wandler auf einen bestimmten Ausgangswert einzustellen, entspricht ein bestimmtes Datenwort mit 4 Bit sowie eine entsprechende Kombination der Signale s1 bis s6. Die Kombination aus dem Inkrementregister 1, dem Phasenregister 2, dem Addierer und dem Speicher 3 wird üblicherweise DDS genannt.

Die zur Anmeldung gehörigen Ansprüche stellen keinen Verzicht auf die Erzielung weitergehenden Schutzes dar.

Sofern sich im Laufe des Verfahrens herausstellt, dass ein Merkmal oder eine Gruppe von Merkmalen nicht zwingend nötig ist, so wird anmelderseitig bereits jetzt eine Formulierung zumindest eines unabhängigen Anspruchs angestrebt, welcher das Merkmal oder die Gruppe von Merkmalen nicht mehr aufweist. Hierbei kann es sich beispielsweise um eine Unterkombination eines am Anmeldetag vorliegenden Anspruchs oder um eine durch weitere Merkmale eingeschränkte Unterkombination eines am Anmeldetag vorliegenden Anspruchs handeln. Derartige neu zu formulierende Ansprüche oder Merkmalskombinationen sind als von der Offenbarung dieser Anmeldung mit abgedeckt zu verstehen.

Es sei ferner darauf hingewiesen, dass Ausgestaltungen, Merkmale und Varianten der Erfindung, welche in den verschiedenen Ausführungen oder Ausführungsbeispielen beschriebenen und/oder in den Figuren gezeigt sind, beliebig untereinander kombinierbar sind. Einzelne oder mehrere Merkmale sind beliebig gegeneinander austauschbar. Hieraus entstehende Merkmalskombinationen sind als von der Offenbarung dieser Anmeldung mit abgedeckt zu verstehen.

Rückbezüge in abhängigen Ansprüchen sind nicht als ein Verzicht auf die Erzielung eines selbständigen, gegenständlichen Schutzes für die Merkmale der rückbezogenen Unteransprüche zu verstehen. Diese Merkmale können auch beliebig mit anderen Merkmalen kombiniert werden.

Merkmale, die lediglich in der Beschreibung offenbart sind oder Merkmale, welche in der Beschreibung oder in einem Anspruch nur in Verbindung mit anderen Merkmalen offenbart sind, können grundsätzlich von eigenständiger erfindungswesentlicher Bedeutung sein. Sie können deshalb auch einzeln zur Abgrenzung vom Stand der Technik in Ansprüche aufgenommen werden.

## Patentansprüche

1. Eine als ASIC ausgebildete elektronische Steuerungseinheit für eine Vorrichtung zum Messen einer Messgröße, wobei die elektronische Steuerungseinheit (ASIC) dazu konfiguriert ist,
- direkt mit einem Parallelschwingkreis (P) verbunden zu werden, welcher aus einer ersten Induktivität (LP, L1) und einer Kapazität (CP) gebildet ist,
- den Parallelschwingkreis (P) mit einer Anregungsfrequenz oszillierend anzuregen, welche aus einem Takt der elektronischen Steuerungseinheit abgeleitet ist,
- direkt mit zumindest einer Messinduktivität (LS1, LS2, LS3, L2) verbunden zu werden, welche zum Abfühlen der Messgröße ausgebildet ist und welche mit der ersten Induktivität (LP, L1) gekoppelt ist, und
- einen die Messgröße anzeigenden Wert an der Messinduktivität (LS1, LS2, LS3, L2) zu messen, wobei
- die elektronische Steuerungseinheit (ASIC) ein Direk-te-Digitale-Synthese (DDS)-Modul aufweist, um die Anregungsfrequenz zu erzeugen.

2. Elektronische Steuerungseinheit (ASIC) nach Anspruch 1, **dadurch gekennzeichnet, dass**
- die elektronische Steuerungseinheit dazu ausgebildet ist, dass der Parallelschwingkreis (P) an einem ersten Portpin und an einem zweiten Portpin der elektronischen Steuerungseinheit (ASIC) angeschlossen wird, wobei der zweite Portpin mit einem zum ersten Portpin invertierten Anregungssignal versorgt wird.

3. Elektronische Steuerungseinheit (ASIC) nach Anspruch 2, **dadurch gekennzeichnet, dass**
- die elektronische Steuerungseinheit (ASIC) dazu ausgebildet ist, dass der Parallelschwingkreis (P)
- parallel zum ersten Portpin mit einer Anzahl weiterer erster Portpins verbunden wird, welche zum ersten Portpin synchron geschalten werden,
und/oder
- parallel zum zweiten Portpin mit einer Anzahl weiterer zweiter Portpins verbunden wird, welche zum zweiten Portpin synchron geschalten werden.

4. Elektronische Steuerungseinheit (ASIC) nach einem der vorhergehenden Ansprüche, **dadurch gekennzeichnet, dass**
- Portpins, welche zum Anschluss des Parallelschwingkreises (P) ausgebildet sind, eine jeweilige Push-Pull-Ausgangsstufe oder eine Tristate-Ausgangsstufe aufweisen.

5. Elektronische Steuerungseinheit (ASIC) nach einem der vorhergehenden Ansprüche,
**dadurch gekennzeichnet, dass**
- die elektronische Steuerungseinheit (ASIC) als Anwendungsspezifisches Standardprodukt, ASSP, ausgebildet ist.

6. Elektronische Steuerungseinheit (ASIC) nach einem der vorhergehenden Ansprüche,
**dadurch gekennzeichnet, dass**
- die elektronische Steuerungseinheit (ASIC) dazu ausgebildet ist, die Messinduktivität (LS1, LS2, LS3, L2) zu vermessen, wenn sie mit einem ersten Pol an einem Portpin der elektronischen Steuerungseinheit (ASIC) angeschlossen ist, und mit einem zweiten Pol mit einem Potential verbunden ist, welches zumindest annähernd der halben Versorgungsspannung der elektronischen Steuerungseinheit (ASIC) entspricht.

7. Elektronische Steuerungseinheit (ASIC) nach Anspruch 6, **dadurch gekennzeichnet, dass**
- die elektronische Steuerungseinheit dazu ausgebildet ist, an einem Portpin ein gepulstes Signal, insbesondere ein Signal mit vorgebbarem Tastverhältnis, auszugeben, um das Potential, welches zumindest annähernd der halben Versorgungsspannung der elektronischen Steuerungseinheit (ASIC) entspricht mittels eines Glättungskondensators (C1) zu erzeugen.

8. Elektronische Steuerungseinheit (ASIC) nach Anspruch 7, **dadurch gekennzeichnet, dass**
- die elektronische Steuerungseinheit (ASIC) dazu konfiguriert ist, beim Einschalten zunächst den Glättungskondensator (C1) auf die zumindest annähernd halbe Versorgungsspannung aufzuladen, während Portpins, an welchen der Parallelschwingkreis (P) angeschlossen wird, den gleichen Logikpegel aufweisen, und erst danach eine Anregung des Parallelschwingkreises (P) zu beginnen.

9. Elektronische Steuerungseinheit (ASIC) nach einem der vorhergehenden Ansprüche,
**dadurch gekennzeichnet, dass**
- die elektronische Steuerungseinheit (ASIC) einen Analog-Digital-Wandler aufweist, um ein von der Messinduktivität (LS1, LS2, LS3, L2) erzeugtes Signal zu erfassen, und dazu konfiguriert ist, unter Berücksichtigung von Aliasing dessen Kennwerte, insbesondere Amplitude, Phase, Realteil und/oder Imaginärteil zu bestimmen, vorzugsweise bei der Anregungsfrequenz.

10. Elektronische Steuerungseinheit (ASIC) nach einem der vorhergehenden Ansprüche,
**dadurch gekennzeichnet, dass**
- die elektronische Steuerungseinheit (ASIC) dazu konfiguriert ist, aus einem erfassten Signal eine Frequenzkomponente bei einer Auswertungsfrequenz zu ermitteln,
- wobei die Auswertungsfrequenz insbesondere die Anregungsfrequenz oder ein Alias der Anregungsfrequenz ist.

11. Elektronische Steuerungseinheit (ASIC) nach einem der vorhergehenden Ansprüche,
**dadurch gekennzeichnet, dass**
- die elektronische Steuerungseinheit (ASIC) dazu konfiguriert ist, durch Verändern der Anregungsfrequenz eine Resonanzfrequenz des Parallelschwingkreises (P) zu ermitteln, und die Anregungsfrequenz identisch zur Resonanzfrequenz oder benachbart zur Resonanzfrequenz einzustellen.

12. Elektronische Steuerungseinheit (ASIC) nach einem der vorhergehenden Ansprüche,
**dadurch gekennzeichnet, dass**
- die elektronische Steuerungseinheit (ASIC) dazu konfiguriert ist, eine erfolgte oder bevorstehende Überschreitung eines maximalen Pegels an einem Portpin zu erkennen, und ansprechend darauf die Anregungsfrequenz zu ändern, insbesondere weiter von der Resonanzfrequenz des Parallelschwingkreises (P) zu beabstanden.

13. Elektronische Steuerungseinheit (ASIC) nach einem der vorhergehenden Ansprüche,
**dadurch gekennzeichnet, dass**
- die elektronische Steuerungseinheit (ASIC) dazu konfiguriert ist, eine Störunterdrückung auszuführen, wozu
- die Anregungsfrequenz kontinuierlich innerhalb eines Messintervalls variiert wird,
und/oder
- die Anregungsfrequenz innerhalb eines Messintervalls variiert wird und abhängig von der Anregungsfrequenz ein Signal-zu-Rausch-Verhältnis ermittelt wird, wobei nachfolgend die Anregungsfrequenz auf einen Wert mit maximalem Signal-zu-Rausch-Verhältnis eingestellt wird.

14. Elektronische Steuerungseinheit (ASIC) nach einem der vorhergehenden Ansprüche,
**dadurch gekennzeichnet, dass**
- die elektronische Steuerungseinheit (ASIC) zumindest einen Analogmultiplizierer aufweist, welcher an einen Portpin zum Anschluss der Messinduktivität angeschlossen ist,
- wobei die elektronische Steuerungseinheit ein Signalmodul aufweist,
- wobei das Signalmodul ein oszillierendes Signal mit einer Frequenz mit definiertem, insbesondere geringem Abstand zur Anregungsfrequenz liefert,
- wobei das Signalmodul als Direkte-Digitale-Synthese (DDS)-Modul ausgebildet ist,
- und wobei ein Ausgangssignal des Analogmultiplizierers, insbesondere ein Differenzsignal, in der elektronischen Steuerungseinheit (ASIC) zur Ermittlung der Messgröße weiterverarbeitet wird.

## Claims

1. Electronic control unit, in the form of an ASIC, for an apparatus for measuring a measured variable, wherein the electronic control unit (ASIC) is configured
- to be connected directly to a parallel resonant circuit (P) that is formed from a first inductance (LP, L1) and a capacitance (CP),
- to excite the parallel resonant circuit (P) into oscillation at an excitation frequency that is derived from a clock of the electronic control unit,
- to be connected directly to at least one measurement inductance (LS1, LS2, LS3, L2) that is designed to detect the measured variable and that is coupled to the first inductance (LP, L1), and
- to measure a value indicating the measured variable using the measurement inductance (LS1, LS2, LS3, L2), wherein
- the electronic control unit (ASIC) has a direct digital synthesis (DDS) module in order to produce the excitation frequency.

2. Electronic control unit (ASIC) according to Claim 1,
**characterized in that**
- the electronic control unit is designed for the parallel resonant circuit (P) to be connected to a first port pin and to a second port pin of the electronic control unit (ASIC), the second port pin being supplied with an excitation signal that is inverted in relation to the first port pin.

3. Electronic control unit (ASIC) according to Claim 2,
**characterized in that**
- the electronic control unit (ASIC) is designed for the parallel resonant circuit (P)
- to be connected in parallel with the first port pin to a number of further first port pins that are connected to the first port pin in sync,
and/or
- to be connected in parallel with the second port pin to a number of further second port pins that are connected to the second port pin in sync.

4. Electronic control unit (ASIC) according to one of the preceding claims,
**characterized in that**
- port pins that are designed for connecting the parallel resonant circuit (P) have a respective push-pull output stage or a tri-state output stage.

5. Electronic control unit (ASIC) according to one of the preceding claims,
**characterized in that**
- the electronic control unit (ASIC) is in the form of an application-specific standard product, ASSP.

6. Electronic control unit (ASIC) according to one of the preceding claims,
**characterized in that**
- the electronic control unit (ASIC) is designed to measure the measurement inductance (LS1, LS2, LS3, L2) when it has a first pole connected to a port pin of the electronic control unit (ASIC) and has a second pole connected to a potential that corresponds to at least approximately half the supply voltage of the electronic control unit (ASIC) .

7. Electronic control unit (ASIC) according to Claim 6,
**characterized in that**
- the electronic control unit is designed to output a pulsed signal, in particular a signal having a prescribable duty ratio, on a port pin in order to produce the potential that corresponds to at least approximately half the supply voltage of the electronic control unit (ASIC) by means of a smoothing capacitor (C1).

8. Electronic control unit (ASIC) according to Claim 7,
**characterized in that**
- the electronic control unit (ASIC) is configured so as, when it is switched on, to first of all charge the smoothing capacitor (C1) to at least approximately half the supply voltage, while port pins to which the parallel resonant circuit (P) is connected have the same logic level and begin excitation of the parallel resonant circuit (P) only afterwards.

9. Electronic control unit (ASIC) according to one of the preceding claims,
**characterized in that**
- the electronic control unit (ASIC) has an analogue-to-digital converter in order to capture a signal generated by the measurement inductance (LS1, LS2, LS3, L2), and is configured to take into consideration aliasing when determining the characteristic values of said signal, in particular amplitude, phase, real part and/or imaginary part, preferably at the excitation frequency.

10. Electronic control unit (ASIC) according to one of the preceding claims,
**characterized in that**
- the electronic control unit (ASIC) is configured to ascertain a frequency component at an evaluation frequency from a captured signal,
- wherein the evaluation frequency is in particular the excitation frequency or an alias of the excitation frequency.

11. Electronic control unit (ASIC) according to one of the preceding claims,
**characterized in that**
- the electronic control unit (ASIC) is configured to alter the excitation frequency in order to ascertain a resonant frequency of the parallel resonant circuit (P), and to set the excitation frequency to be identical to the resonant frequency or adjacent to the resonant frequency.

12. Electronic control unit (ASIC) according to one of the preceding claims,
**characterized in that**
- the electronic control unit (ASIC) is configured to identify when an exceeding of a maximum level has occurred or is imminent on a port pin, and to respond thereto by changing the excitation frequency, in particular by spacing it further apart from the resonant frequency of the parallel resonant circuit (P).

13. Electronic control unit (ASIC) according to one of the preceding claims,
**characterized in that**
- the electronic control unit (ASIC) is configured to carry out interference rejection, to which end
- the excitation frequency is varied continuously within a measurement range,
and/or
- the excitation frequency is varied within a measurement range and the excitation frequency is taken as a basis for ascertaining a signal-to-noise ratio, the excitation frequency subsequently being set to a value having a maximum signal-to-noise ratio.

14. Electronic control unit (ASIC) according to one of the preceding claims,
**characterized in that**
- the electronic control unit (ASIC) has at least one analogue multiplier that is connected to a port pin for connecting the measurement inductance,
- wherein the electronic control unit has a signal module,
- wherein the signal module delivers an oscillating signal at a frequency having a defined, in particular small, spacing from the excitation frequency,
- wherein the signal module is in the form of a direct digital synthesis (DDS) module,
- and wherein an output signal of the analogue multiplier, in particular a difference signal, is processed further in the electronic control unit (ASIC) to ascertain the measured variable.

## Revendications

1. Unité de commande électronique réalisée sous forme d'ASIC, destinée à un dispositif de mesure d'une grandeur de mesure, l'unité de commande électronique (ASIC) étant configurée pour
- être reliée directement à un circuit oscillant parallèle (P) qui est formé par une première inductance (LP, L1) et une capacité (CP),
- faire osciller le circuit oscillant parallèle (P) à une fréquence d'excitation qui est dérivée d'une cadence d'horloge de l'unité de commande électronique,
- être reliée directement à au moins une inductance de mesure (LS1, LS2, LS3, L2) qui est réalisée pour détecter la grandeur de mesure et qui est couplée à la première inductance (LP, L1), et
- mesurer une valeur indiquant la grandeur de mesure au niveau de l'inductance de mesure (LS1, LS2, LS3, L2), dans laquelle
- l'unité de commande électronique (ASIC) présente un module de synthèse numérique directe (DDS) pour produire la fréquence d'excitation.

2. Unité de commande électronique (ASIC) selon la revendication 1, **caractérisée en ce que**
- l'unité de commande électronique est réalisée pour que le circuit oscillant parallèle (P) soit connecté à une première broche de borne et à une deuxième broche de borne de l'unité de commande électronique (ASIC), la deuxième broche de borne étant alimentée par un signal d'excitation inversé par rapport à la première broche de borne.

3. Unité de commande électronique (ASIC) selon la revendication 2, **caractérisée en ce que**
- l'unité de commande électronique (ASIC) est réalisée pour que le circuit oscillant parallèle (P)
- soit connecté en parallèle à la première broche de borne avec un certain nombre d'autres premières broches de borne qui sont connectées de manière synchrone avec la première broche de borne, et/ou
- soit connecté en parallèle à la deuxième broche de borne avec un certain nombre d'autres deuxièmes broches de borne qui sont connectées de manière synchrone avec la deuxième broche de borne.

4. Unité de commande électronique (ASIC) selon l'une quelconque des revendications précédentes, **caractérisée en ce que**
- des broches de borne qui sont réalisées pour la connexion du circuit oscillant parallèle (P) présentent un étage de sortie push-pull ou un état de sortie à trois états respectif.

5. Unité de commande électronique (ASIC) selon l'une quelconque des revendications précédentes, **caractérisée en ce que**
- l'unité de commande électronique (ASIC) est réalisée sous la forme d'un produit standard spécifique à une application, ASSP.

6. Unité de commande électronique (ASIC) selon l'une quelconque des revendications précédentes, **caractérisée en ce que**
- l'unité de commande électronique (ASIC) est réalisée pour mesurer l'inductance de mesure (LS1, LS2, LS3, L2) lorsqu'elle est reliée à un premier pôle sur une broche de borne de l'unité de commande électronique (ASIC) et est reliée à un deuxième pôle ayant un potentiel qui correspond au moins approximativement à la moitié de la tension d'alimentation de l'unité de commande électronique (ASIC).

7. Unité de commande électronique (ASIC) selon la revendication 6, **caractérisée en ce que**
- l'unité de commande électronique est réalisée pour sortir à une broche de borne un signal pulsé, en particulier un signal ayant un rapport cyclique prédéfinissable afin de produire le potentiel qui correspond au moins approximativement à la moitié de la tension d'alimentation de l'unité de commande électronique (ASIC) au moyen d'un condensateur de lissage (C1).

8. Unité de commande électronique (ASIC) selon la revendication 7, **caractérisée en ce que**
- l'unité de commande électronique (ASIC) est configurée lors de la mise sous tension pour recharger d'abord le condensateur de lissage (C1) au moins approximativement à la moitié de la tension d'alimentation alors que des broches de borne auxquelles est connecté le circuit oscillant parallèle (P) présentent le même niveau logique, et pour commencer seulement ensuite une excitation du circuit oscillant parallèle (P).

9. Unité de commande électronique (ASIC) selon l'une quelconque des revendications précédentes, **caractérisée en ce que**
- l'unité de commande électronique (ASIC) présente un convertisseur analogique/numérique pour détecter un signal produit par l'inductance de mesure (LS1, LS2, LS3, L2), et est configurée pour déterminer, en tenant compte d'un crénelage, les valeurs caractéristiques de celui-ci, en particulier l'amplitude, la phase, la partie réelle et/ou la partie imaginaire, de préférence à la fréquence d'excitation.

10. Unité de commande électronique (ASIC) selon l'une quelconque des revendications précédentes, **caractérisée en ce que**
- l'unité de commande électronique (ASIC) est configurée pour déterminer une composante de fréquence à partir d'un signal détecté à une fréquence d'évaluation,
- la fréquence d'évaluation étant en particulier la fréquence d'excitation ou un alias de la fréquence d'excitation.

11. Unité de commande électronique (ASIC) selon l'une quelconque des revendications précédentes, **caractérisée en ce que**
- l'unité de commande électronique (ASIC) est configurée pour établir une fréquence de résonance du circuit oscillant parallèle (P) en faisant varier la fréquence d'excitation, et pour régler la fréquence d'excitation de manière identique à la fréquence de résonance ou proche de la fréquence de résonance.

12. Unité de commande électronique (ASIC) selon l'une quelconque des revendications précédentes, **caractérisée en ce que**
- l'unité de commande électronique (ASIC) est configurée pour identifier un dépassement survenu ou imminent d'un niveau maximal à une broche de borne, et pour modifier en réponse à cela la fréquence d'excitation, en particulier pour l'éloigner davantage de la fréquence de résonance du circuit oscillant parallèle (P).

13. Unité de commande électronique (ASIC) selon l'une quelconque des revendications précédentes, **caractérisée en ce que**
- l'unité de commande électronique (ASIC) est configurée pour effectuer une suppression des interférences, pour laquelle
- la fréquence d'excitation est amenée à varier en continu à l'intérieur d'un intervalle de mesure, et/ou
- la fréquence d'excitation est amenée à varier à l'intérieur d'un intervalle de mesure, et en fonction de la fréquence d'excitation un rapport signal/bruit est établi, la fréquence d'excitation étant par la suite réglée sur une valeur ayant un rapport signal/bruit maximal.

14. Unité de commande électronique (ASIC) selon l'une quelconque des revendications précédentes, **caractérisée en ce que**
- l'unité de commande électronique (ASIC) présente au moins un multiplicateur analogique qui est connecté à une broche de borne pour connecter l'inductance de mesure,
- l'unité de commande électronique présentant un module de signal,
- le module de signal fournissant un signal oscillant ayant une fréquence avec une distance définie, en particulier faible, par rapport à la fréquence d'excitation,
- le module de signal est réalisé sous la forme d'un module de synthèse numérique directe (DDS),
- et un signal de sortie du multiplicateur analogique, en un signal de différence, étant traité ultérieurement dans l'unité de commande électronique (ASIC) pour établir les grandeurs de mesure.
